(19) Europäisches Patentamt / European Patent Office / Office européen des brevets

(11) **EP 1 696 476 B1**

(12) **EUROPEAN PATENT SPECIFICATION**

(45) Date of publication and mention
of the grant of the patent:
**18.02.2015 Bulletin 2015/08**

(51) Int Cl.:
*H01L 21/306* (2006.01)   *H01L 21/02* (2006.01)
*H01L 21/67* (2006.01)   *G03F 7/42* (2006.01)

(21) Application number: **06003683.7**

(22) Date of filing: **23.02.2006**

(54) **Method of surface processing substrate, method of cleaning substrate, and programs for implementing the methods**

Verfahren zur Behandlung von Substrat Oberflächen, zur Reinigung von Substraten und für die Verfahren implementierende Programme

Procédés pour le traitement de surface et de nettoyage d'un substrat et des programmes pour implémenter les procédés

(84) Designated Contracting States:
**AT BE BG CH CY CZ DE DK EE ES FI FR GB GR HU IE IS IT LI LT LU LV MC NL PL PT RO SE SI SK TR**

(30) Priority: **23.02.2005 JP 2005047361**
**26.09.2005 JP 2005278844**

(43) Date of publication of application:
**30.08.2006 Bulletin 2006/35**

(73) Proprietor: **TOKYO ELECTRON LIMITED**
**Minato-ku**
**Tokyo 107-8481 (JP)**

(72) Inventors:
• **Nishimura, Eiichi**
**Minato-ku**
**Tokyo 107-8481 (JP)**
• **Orii, Takehiko**
**Minato-ku**
**Tokyo 107-8481 (JP)**

(74) Representative: **Hoffmann Eitle**
**Patent- und Rechtsanwälte PartmbB**
**Arabellastraße 30**
**81925 München (DE)**

(56) References cited:
**US-A- 5 282 925**

• **JUNGYUP KIM ET AL: "Megasonic free single wafer ozone jet cleans- concept and feasibility" 2003 IEEE INTERNATIONAL SYMPOSIUM ON SEMICONDUCTOR MANUFACTURING. CONFERENCE PROCEEDINGS. ( ISSM 2003 ). SAN JOSE, CA, SEPT. 30 - OCT. 2, 2003; [IEEE INTERNATIONAL SYMPOSIUM ON SEMICONDUCTOR MANUFACTURING], NEW YORK, NY : IEEE, US, 30 September 2003 (2003-09-30), pages 233-236, XP010667443 ISBN: 978-0-7803-7894-0**

EP 1 696 476 B1

**Description**

BACKGROUND OF THE INVENTION

Field of the Invention

The present invention as claimed in claims 1, 18 relates to a method of surface processing a substrate, a method of cleaning a substrate, and programs for implementing the methods, and more particularly to a method of surface processing a substrate in which silicon oxide ($SiO_2$) that has been formed on a substrate surface is removed.

Description of the Related Art

Conventionally, a wet cleaning method has been widely used for removing particles, contamination such as a surface coating film of adsorbed molecules, metal or organic matter, and silicon native oxide on a silicon wafer (hereinafter referred to merely as a "wafer"), and for removing watermarks or the like formed on a wafer. The art that forms the basis of the conventional wet cleaning method is the RCA cleaning method, which was developed in the 1960's, and many cleaning methods using this art have been proposed.

Of wafer surface cleaning methods, for example cleaning methods implemented before forming a gate insulating film on a wafer and cleaning methods for wafer surface that has been revealed through contact hole formation, the most common cleaning method is that described below.

First, cleaning is carried out using APM (ammonium hydroxide / hydrogen peroxide mixture), also known as SCI (hereinafter referred to as "SCI cleaning") to remove particles on the wafer. The SCI cleaning is generally carried out using a solution produced from $NH_4OH$ (29 wt% aqueous solution) and $H_2O_2$ (30 wt% aqueous solution) such that the $NH_4OH:H_2O_2:H_2O$ ratio is in a range of 1:1:5 to 1:2:7 as a cleaning liquid, and the cleaning is carried out by immersing the wafer for 5 to 20 minutes at a solution temperature of 65 to 85°C. A native oxide film or pseudo-$SiO_2$ layer is formed on the surface of the wafer cleaned in the SC1 cleaning, and hence the wafer surface becomes hydrophilic through the SC1 cleaning.

Next, pure water cleaning is carried out, and then to remove the native oxide film or pseudo-$SiO_2$ layer formed on the wafer through the SC1 cleaning, DHF (dilute hydrofluoric acid) cleaning is carried out. The DHF cleaning is generally carried out using a solution produced from hydrogen fluoride (HF) (49 wt% aqueous solution) such that the $HF:H_2O$ ratio is 1:30 as a cleaning liquid, and the cleaning is carried out by immersing the wafer for 40 to 60 seconds. Contamination can be removed through the DHF cleaning. Next, pure water cleaning is carried out, and then finally spin drying is carried out using a rinser dryer.

Moreover, there is also a cleaning method in which after the SC1 cleaning and pure water cleaning, cleaning is carried out using HPM (hydrochloric acid / hydrogen peroxide / water mixture), also known as SC2 (hereinafter referred to as "SC2 cleaning"), then pure water cleaning is carried out, and then the DHF cleaning is carried out. The SC2 cleaning is carried out to remove metal contamination, and is carried out using a solution produced from HCl and $H_2O_2$ as a cleaning liquid. In the SC2 cleaning, as for the SC1 cleaning, a native oxide film or pseudo-$SiO_2$ layer is formed on the wafer surface, and hence the wafer surface becomes hydrophilic.

In the conventional cleaning method described above, the native oxide film or pseudo-$SiO_2$ layer is removed through contact of the wafer surface with the DHF cleaning liquid so as to reveal the underlying silicon, and as a result the wafer surface becomes hydrophobic through the DHF cleaning, and hence water droplets remain on the surface when the wafer is pulled out from the DHF cleaning liquid. Such water droplets become watermarks through the spin drying. The watermarks are thought to be silicon oxide ($SiO_2$) formed locally through the water droplets during transfer or drying of the wafer, or $H_2SiF_6$ stains remaining after the drying caused by the formed silicon oxide dissolving out into the water droplets and drying the water.

Such watermarks act as masking in etching processing carried out after the cleaning processing, and hamper film formation processing, and hence may cause a degradation in properties of an electronic device manufactured from the wafer. Suppressing the formation of watermarks in the cleaning processing is thus an issue in cleaning/drying art.

Meanwhile, in the spin drying step described above, the wafer is rotated at high speed and hence may become charged so that particles become electrostatically attached thereto, or may have dust or contaminating mist from the rotating apparatus attached thereto. There is thus a problem that the wafer surface is prone to becoming dirty. Moreover, native oxide of film thickness not less than 0.5 nm is formed on a wafer surface exposed to the atmosphere, and it is known that such native oxide is a large problem for forming a gate insulating film of film thickness not more than 65 nm.

A method is known in which, to suppress the formation of watermarks and native oxide, isopropyl alcohol (IPA) is used in the drying step. In the drying method using IPA (hereinafter referred to as "IPA drying"), after the pure water cleaning, the wafer surface is exposed to IPA vapor so that water on the wafer surface is changed into IPA condensate, and then the attached IPA condensate is evaporated in a clean air atmosphere, whereby the wafer surface can be dried quickly.

In a cleaning method using IPA drying, specifically, a plurality of processing tanks for carrying out liquid chemical (APM, DHF) cleaning, pure water cleaning, and the IPA drying respectively are provided in a row with openable/closable partitioning curtains therebetween, and the cleaning processing is carried out by moving the wafer between these processing tanks in order. In the IPA drying method, because the solubility of IPA in water is high, and moreover the wettability of IPA to a hydrophobic silicon surface is high (the surface tension is low), the drying processing can be carried out without water droplets being formed on the wafer surface, and hence watermarks do not arise. Moreover, purging the processing chamber with $N_2$ is easy, and hence formation of native oxide on the wafer can be prevented (see, for example, Japanese Laid-open Patent Publication (Kokai) No. 2002-166237).

However, IPA molecules (carbon-based organic matter) may remain on the wafer surface after the IPA drying. It is feared that these IPA molecules may adversely affect gate oxide film properties (see Jpn. J. Appl. Phys. Vol.37(1998) 1137-1139, Part 1, No.3B, 30 March 1998, Title: The Effect of Isopropyl Alcohol Adsorption on the Electrical Characteristics of Thin Oxide, Authors: Kumi Motai, Toshihiko Itoga and Takashi Irie). Even though formation of watermarks is suppressed by using IPA drying, it has thus been difficult to obtain a clean wafer surface after the drying. JUNGYUP KIM ET AL: "Megasonic free single wafer ozone jet cleans- concept and feasibility", 2003 IEEE INTERNATIONAL SYMPOSIUM ON SEMICONDUCTOR MANUFACTURING discloses cleaning of oxide particles from a wafer using liquid HF and $NH_4OH$ and a jet of $O_3$. US5282925 describes etching of $SiO_2$ by condensing HF and $NH_3$ gases onto the material to be etched by using low temperature and high pressure to induce the condensation.

## SUMMARY OF THE INVENTION

It is an object of the present invention to provide a method of surface processing a substrate, a method of cleaning a substrate, and programs for implementing the methods, that enable deposit to be removed from a substrate so as to obtain a clean substrate.

To attain the above object, there is provided a method of surface processing a substrate in which deposit is removed from the substrate, the method comprising a liquid chemical cleaning step of cleaning the substrate with a liquid chemical, a deposit exposure step of exposing the deposit to an atmosphere of a mixed gas containing ammonia and hydrogen fluoride under a predetermined pressure, and a deposit heating step of heating to a predetermined temperature the deposit that has been exposed to the atmosphere of the mixed gas.

According to the above method, the deposit on the substrate that has been cleaned with the liquid chemical is exposed to an atmosphere of a mixed gas containing ammonia and hydrogen fluoride under a predetermined pressure, and then the deposit that has been exposed to the atmosphere of the mixed gas is heated to a predetermined temperature. Upon the deposit being exposed to the atmosphere of the mixed gas containing ammonia and hydrogen fluoride under the predetermined pressure, a product that is a complex based on the deposit and the mixed gas is produced. Then, upon the product being heated to the predetermined temperature, the product is vaporized. Through the product being vaporized, the deposit, for example oxide, on the substrate can be removed. It is thus possible to remove the deposit, for example oxide, from the substrate so as to obtain a clean substrate.

Preferably, in the deposit exposure step, the substrate is subjected to plasma-less etching.

According to the above method, the substrate is subjected to plasma-less etching. As a result, charge is not accumulated on a gate electrode in an electronic device manufactured from the substrate, and hence degradation or destruction of a gate oxide film can be prevented. Moreover, the electronic device is not irradiated with energetic particles, and hence semiconductor damage due to being struck by such energetic particles (i.e. crystal defects) can be prevented from occurring. Furthermore, unanticipated chemical reactions caused by plasma do not occur, and hence generation of impurities can be prevented, whereby contamination of the processing chambers in which the substrate is processed can be prevented.

Also, preferably, in the deposit exposure step, the substrate is subjected to dry cleaning.

According to the above method, the substrate is subjected to dry cleaning. As a result, there is no attachment of water molecules in a liquid state to the substrate, and hence there is no formation of a silicon oxide film as deposit on the surface of the substrate. A cleaner substrate can thus be obtained. Moreover, changes in properties of the substrate surface can be suppressed, and hence a decrease in wiring reliability can be reliably prevented.

Preferably, the predetermined pressure in the deposit exposure step is in a range of $6.7 \times 10^{-2}$ to 4.0 Pa, and the predetermined temperature in the deposit heating step is in a range of 100 to 200°C.

According to the above method, the deposit on the substrate is exposed to the atmosphere of the mixed gas containing ammonia and hydrogen fluoride under a pressure in a range of $6.7 \times 10^{-2}$ to 4.0 Pa. As a result, there is no attachment of water molecules in a liquid state to the substrate, and hence there is no formation of a silicon oxide film as deposit on the surface of the substrate. Moreover, the deposit that has been exposed to the atmosphere of the mixed gas and thus converted into a complex is heated to a temperature in a range of 100 to 200°C. As a result, there is no attachment of water molecules in a liquid state to the substrate, and hence there is no formation of a silicon oxide film on the surface of the substrate. A cleaner substrate can thus be obtained.

Preferably, the deposit is silicon oxide formed on the substrate.

According to the above method, the deposit on the substrate exposed to the atmosphere of the mixed gas containing ammonia and hydrogen fluoride under the predetermined pressure and then heated to the predetermined temperature is silicon oxide. As a result, oxide constituting watermarks or the like formed on the substrate can be removed.

Preferably, the method further comprises a product production condition deciding step of measuring a shape of the deposit, and deciding at least one of a volumetric flow rate ratio of the hydrogen fluoride to the ammonia in the mixed gas and the predetermined pressure in accordance with the measured shape.

According to the above method, the shape of the deposit on the substrate is measured, and at least one of the volumetric flow rate ratio of the hydrogen fluoride to the ammonia in the mixed gas and the predetermined pressure is decided in accordance with the measured shape. As a result, the amount removed of the deposit can be controlled precisely, and hence the efficiency of the substrate surface processing can be improved.

Preferably, the method further comprises a rinsing liquid cleaning step of cleaning the substrate with a rinsing liquid after the liquid chemical cleaning step.

According to the above method, the substrate is cleaned with a rinsing liquid after being cleaned with the liquid chemical. As a result, contamination and native oxide that has been removed from the substrate by the liquid chemical can be washed away together with the liquid chemical.

More preferably, the method further comprises a spin drying step of spin drying the substrate after the rinsing liquid cleaning step.

According to the above method, the substrate is spin dried after being cleaned with the rinsing liquid. As a result, carbon-based organic matter can be prevented from remaining on the substrate.

To attain the above object, in a second example, there is provided a method of cleaning a substrate having a first layer formed on the substrate, a photoresist layer having a predetermined pattern formed on the first layer, and at least on connecting hole fabricated in the first layer by etching using the photoresist layer, the method comprising a photoresist removal step of removing the photoresist layer, a hydrophilic cleaning step of cleaning the substrate with a liquid chemical that forms a hydrophilic layer on a surface of the substrate, a deposit exposure step of exposing the substrate to an atmosphere of a mixed gas containing ammonia and hydrogen fluoride under a predetermined pressure, and a deposit heating step of heating to a predetermined temperature the substrate that has been exposed to the atmosphere of the mixed gas.

According to the above method, the substrate having connecting holes fabricated in a first layer formed on the substrate by etching using a photoresist layer having a predetermined pattern formed on the first layer is subjected to removal of the photoresist layer, then to cleaning with a liquid chemical that forms a hydrophilic layer on a surface of the substrate, then to exposure to an atmosphere of a mixed gas containing ammonia and hydrogen fluoride under a predetermined pressure, and then to heating to a predetermined temperature. As a result, predetermined contamination can be removed by the liquid chemical. Moreover, although a hydrophilic layer (native oxide film or pseudo-$SiO_2$ layer) is formed on the substrate surface through the cleaning with the liquid chemical, effects as for the first aspect can be achieved, i.e. deposit comprising the hydrophilic layer (native oxide film etc.) on the substrate can be removed. A clean substrate can thus be obtained. Moreover, the present cleaning method can even be used on a substrate that has already been cleaned using an unknown cleaning method.

Preferably, the liquid chemical is one of SC1 and SC2.

According to the above method, the liquid chemical is one of SC1 and SC2. As a result, particles or metal contamination can be removed from the substrate.

Also preferably, the hydrophilic layer is a silicon native oxide film.

According to the above method, the hydrophilic layer is a silicon native oxide film. As a result, the effects for the second aspect described above can be achieved reliably.

To attain the above object, in a third example, there is provided a method of cleaning a substrate having a first layer formed on the substrate, a photoresist layer having a predetermined pattern formed on the first layer, and at least one connecting hole fabricated in the first layer by etching using the photoresist layer, the method comprising a photoresist removal step of removing the photoresist layer, a hydrophobic cleaning step of cleaning the substrate with a liquid chemical that forms a hydrophobic surface on a surface of the substrate, a deposit exposure step of exposing the substrate to an atmosphere of a mixed gas containing ammonia and hydrogen fluoride under a predetermined pressure, and a deposit heating step of heating to a predetermined temperature the substrate that has been exposed to the atmosphere of the mixed gas.

According to the above method, the substrate having connecting holes fabricated in a first layer formed on the substrate by etching using a photoresist layer having a predetermined pattern formed on the first layer is subjected to removal of the photoresist layer, then to cleaning with a liquid chemical that forms a hydrophobic surface on a surface of the substrate, then to exposure to an atmosphere of a mixed gas containing ammonia and hydrogen fluoride under a predetermined pressure, and then to heating to a predetermined temperature. As a result, predetermined contamination can be removed by the liquid chemical. Moreover, although watermarks are formed as deposit due to a hydrophobic surface being formed on the substrate surface through the cleaning with the liquid chemical, effects as for the first aspect can be achieved, i.e. the deposit on the hydrophobic surface of the substrate can be removed. A clean substrate can thus be obtained. Moreover, the present cleaning method can even be used on a substrate that has already been cleaned using an unknown cleaning method.

Preferably, the liquid chemical is a hydrogen fluoride aqueous solution.

According to the above method, the liquid chemical is a hydrogen fluoride aqueous solution. As a result, native oxide can be removed from the substrate.

To attain the above object, in a fourth example, there is provided a method of cleaning a substrate having a first layer formed on the substrate, a photoresist layer having a predetermined pattern formed on the first layer, and at least one connecting hole fabricated in the first layer by etching using the photoresist layer, the method comprising a photoresist removal step of removing the photoresist layer, a first wet cleaning step of cleaning the substrate with SC1, a second wet cleaning step of cleaning with SC2 the substrate that has been cleaned in the first wet cleaning step, a third wet cleaning step of cleaning with a hydrogen fluoride aqueous solution the substrate that has been cleaned in the second wet cleaning step, a drying step of drying the substrate that has been cleaned in the third wet cleaning step, a deposit exposure step of exposing the substrate that has been dried in the drying step to an atmosphere of a mixed gas containing ammonia and hydrogen fluoride under a predetermined pressure, and a deposit heating step of heating to a predetermined temperature the substrate that has been exposed to the atmosphere of the mixed gas.

According to the above method, the substrate having connecting holes fabricated in a first layer formed on the substrate by etching using a photoresist layer having a predetermined pattern formed on the first layer is subjected to removal of the photoresist layer, then to cleaning with SC1, then to cleaning with SC2, then to cleaning with a hydrogen fluoride aqueous solution, then to drying, then to exposure to an atmosphere of a mixed gas containing ammonia and hydrogen fluoride under a predetermined pressure, and then to heating to a predetermined temperature. As a result, contamination, native oxide and so on can be removed. Moreover, although watermarks are formed as deposit through the drying, effects as for the first aspect can be achieved, i.e. the deposit on the substrate can be removed. A clean substrate can thus be obtained. In particular, because cleaning with SC2 which can remove metal contamination is carried out, the present cleaning method is effective for cleaning a substrate having metal contamination attached thereto as deposit.

To attain the above object, in a fifth example, there is provided a method of cleaning a substrate having a first layer formed on the substrate, a photoresist layer having a predetermined pattern formed on the first layer, and at least one connecting hole fabricated in the first layer by etching using the photoresist layer, the method comprising a photoresist removal step of removing the photoresist layer, a first wet cleaning step of cleaning the substrate with SC1, a second wet cleaning step of cleaning with a hydrogen fluoride aqueous solution the substrate that has been cleaned in the first wet cleaning step, a drying step of drying the substrate that has been cleaned in the second wet cleaning step, a deposit exposure step of exposing the substrate that has been dried in the drying step to an atmosphere of a mixed gas containing ammonia and hydrogen fluoride under a predetermined pressure, and a deposit heating step of heating to a predetermined temperature the substrate that has been exposed to the atmosphere of the mixed gas.

According to the above method, the substrate having connecting holes fabricated in a first layer formed on the substrate by etching using a photoresist layer having a predetermined pattern formed on the first layer is subjected to removal of the photoresist layer, then to cleaning with SC1, then to cleaning with a hydrogen fluoride aqueous solution, then to drying, then to exposure to an atmosphere of a mixed gas containing ammonia and hydrogen fluoride under a predetermined pressure, and then to heating to a predetermined temperature. As a result, contamination, native oxide and so on can be removed. Moreover, although watermarks are formed as deposit through the drying, effects as for the first aspect can be achieved, i.e. the deposit on the substrate can be removed. A clean substrate can thus be obtained.

To attain the above object, in a sixth example, there is provided a method of cleaning a substrate having a first layer formed on the substrate, a photoresist layer having a predetermined pattern formed on the first layer, and at least one connecting hole fabricated in the first layer by etching using the photoresist layer, the method comprising a photoresist removal step of removing the photoresist layer, a first wet cleaning step of cleaning the substrate with SC1, a second wet cleaning step of cleaning with SC2 the substrate that has been cleaned in the first wet cleaning step, a drying step of drying the substrate that has been cleaned in the second wet cleaning step, a deposit exposure step of exposing the substrate that has been dried in the drying step to an atmosphere of a mixed gas containing ammonia and hydrogen fluoride under a predetermined pressure, and a deposit heating step of heating to a predetermined temperature the substrate that has been exposed to the atmosphere of the mixed gas.

According to the above method, the substrate having connecting holes fabricated in a first layer formed on the substrate by etching using a photoresist layer having a predetermined pattern formed on the first layer is subjected to removal of the photoresist layer, then to cleaning with SC1, then to cleaning with SC2, then to drying, then to exposure to an atmosphere of a mixed gas containing ammonia and hydrogen fluoride under a predetermined pressure, and then to heating to a predetermined temperature. As a result, contamination, native oxide and so on can be removed. Moreover, although watermarks are formed as deposit through the drying, effects as for the first aspect can be achieved, i.e. the deposit on the substrate can be removed. A clean substrate can thus be obtained.

To attain the above object, in a seventh example, there is provided a method of cleaning a substrate having a first layer formed on the substrate, a photoresist layer having a predetermined pattern formed on the first layer, and at least one connecting hole fabricated in the first layer by etching using the photoresist layer, the method comprising a photoresist removal step of removing the photoresist layer, a first wet cleaning step of cleaning the substrate with SC1, a second wet cleaning step of cleaning with a hydrogen fluoride aqueous solution the substrate that has been cleaned in the first wet cleaning step, a third wet cleaning step of cleaning with SC2 the substrate that has been cleaned in the second wet cleaning step, a drying step of drying the substrate that has been cleaned in the third wet cleaning step, a deposit exposure step of exposing the substrate that has been dried in the drying step to an atmosphere of a mixed gas containing ammonia and hydrogen fluoride under a predetermined pressure, and a deposit heating step of heating to a predetermined temperature the substrate that has been exposed to the atmosphere of the mixed gas.

According to the above method, the substrate having connecting holes fabricated in a first layer formed on the substrate by etching using a photoresist layer having a predetermined pattern formed on the first layer is subjected to removal of the photoresist layer, then to cleaning with SC1, then to cleaning with a hydrogen fluoride aqueous solution, then to cleaning with SC2, then to drying, then to exposure to an atmosphere of a mixed gas containing ammonia and hydrogen fluoride under a predetermined pressure, and then to heating to a predetermined temperature. As a result, contamination, native oxide and so on can be removed. Moreover, although watermarks are formed as deposit through the drying, effects as for the first aspect can be achieved, i.e. the deposit on the substrate can be removed. A clean substrate can thus be obtained. In particular, because cleaning with SC2 which can remove metal contamination is carried out, the present cleaning method is effective for cleaning a substrate having metal contamination attached thereto as deposit.

To attain the above object, in an eighth example, there is provided a program for causing a computer to execute a method of surface processing a substrate in which deposit is removed from the substrate, the program comprising a liquid chemical cleaning module for cleaning the substrate with a liquid chemical, a deposit exposure module for exposing the deposit to an atmosphere of a mixed gas containing ammonia and hydrogen fluoride under a predetermined pressure, and a deposit heating module for heating to a predetermined temperature the deposit that has been exposed to the atmosphere of the mixed gas.

According to the above program, effects as for the first aspect can be achieved.

To attain the above object, in a ninth example, there is provided a program for causing a computer to execute a method of cleaning a substrate having a first layer formed on the substrate, a photoresist layer having a predetermined pattern formed on the first layer, and at least one connecting hole fabricated in the first layer by etching using the photoresist layer, the program comprising a photoresist removal module for removing the photoresist layer, a hydrophilic cleaning module for cleaning the substrate with a liquid chemical that forms a hydrophilic layer on a surface of the substrate, a deposit exposure module for exposing the substrate to an atmosphere of a mixed gas containing ammonia and hydrogen fluoride under a predetermined pressure, and a deposit heating module for heating to a predetermined temperature the substrate that has been exposed to the atmosphere of the mixed gas.

According to the above program, effects as for the second aspect can be achieved.

To attain the above object, in a tenth example, there is provided a program for causing a computer to execute a method of cleaning a substrate having a first layer formed on the substrate, a photoresist layer having a predetermined pattern formed on the first layer, and at least one connecting hole fabricated in the first layer by etching using the photoresist layer, the program comprising a photoresist removal module for removing the photoresist layer, a hydrophobic cleaning module for cleaning the substrate with a liquid chemical that forms a hydrophobic surface on a surface of the substrate, a deposit exposure module for exposing the substrate to an atmosphere of a mixed gas containing ammonia and hydrogen fluoride under a predetermined pressure, and a deposit heating module for heating to a predetermined temperature the substrate that has been exposed to the atmosphere of the mixed gas.

According to the above program, effects as for the third aspect can be achieved.

To attain the above object, in an eleventh example, there is provided a program for causing a computer to execute a method of cleaning a substrate having a first layer formed on the substrate, a photoresist layer having a predetermined pattern formed on the first layer, and at least one connecting hole fabricated in the first layer by etching using the photoresist layer, the program comprising a photoresist removal module for removing the photoresist layer, a first wet cleaning module for cleaning the substrate with SC1, a second wet cleaning module for cleaning with SC2 the substrate that has been cleaned in the first wet cleaning module, a third wet cleaning module for cleaning with a hydrogen fluoride aqueous solution the substrate that has been cleaned in the second wet cleaning module, a drying module for drying the substrate that has been cleaned in the third wet cleaning module, a deposit exposure module for exposing the substrate that has been dried in the drying module to an atmosphere of a mixed gas containing ammonia and hydrogen fluoride under a predetermined pressure, and a deposit heating module for heating to a predetermined temperature the substrate that has been exposed to the atmosphere of the mixed gas.

According to the above program, effects as for the fourth aspect can be achieved.

To attain the above object, in a twelfth example, there is provided a program for causing a computer to execute a method of cleaning a substrate having a first layer formed on the substrate, a photoresist layer having a predetermined pattern formed on the first layer, and at least one connecting hole fabricated in the first layer by etching using the photoresist layer, the program comprising a photoresist removal module for removing the photoresist layer, a first wet cleaning module for cleaning the substrate with SC1, a second wet cleaning module for cleaning with a hydrogen fluoride aqueous solution the substrate that has been cleaned in the first wet cleaning module, a drying module for drying the substrate that has been cleaned in the second wet cleaning module, a deposit exposure module for exposing the substrate that has been dried in the drying module to an atmosphere of a mixed gas containing ammonia and hydrogen fluoride under a predetermined pressure, and a deposit heating module for heating to a predetermined temperature the substrate that has been exposed to the atmosphere of the mixed gas.

According to the above program, effects as for the fifth aspect can be achieved.

To attain the above object, in a thirteenth example, there is provided a program for causing a computer to execute a method of cleaning a substrate having a first layer formed on the substrate, a photoresist layer having a predetermined pattern formed on the first layer, and at least one connecting hole fabricated in the first layer by etching using the photoresist layer, the program comprising a photoresist removal module for removing the photoresist layer, a first wet cleaning module for cleaning the substrate with SC1, a second wet cleaning module for cleaning with SC2 the substrate that has been cleaned in the first wet cleaning module, a drying module for drying the substrate that has been cleaned in the second wet cleaning module, a deposit exposure module for exposing the substrate that has been dried in the drying module to an atmosphere of a mixed gas containing ammonia and hydrogen fluoride under a predetermined pressure, and a deposit heating module for heating to a predetermined temperature the substrate that has been exposed to the atmosphere of the mixed gas.

According to the above program, effects as for the sixth aspect can be achieved.

To attain the above object, in a fourteenth example, there is provided a program for causing a computer to execute a method of cleaning a substrate having a first layer formed on the substrate, a photoresist layer having a predetermined pattern formed on the first layer, and at least one connecting hole fabricated in the first layer by etching using the photoresist layer, the program comprising a photoresist removal module for removing the photoresist layer, a first wet cleaning module for cleaning the substrate with SC1, a second wet cleaning module for cleaning with a hydrogen fluoride aqueous solution the substrate that has been cleaned in the first wet cleaning module, a third wet cleaning module for cleaning with SC2 the substrate that has been cleaned in the second wet cleaning module, a drying module for drying the substrate that has been cleaned in the third wet cleaning module, a deposit exposure module for exposing the substrate that has been dried in the drying module to an atmosphere of a mixed gas containing ammonia and hydrogen fluoride under a predetermined pressure, and a deposit heating module for heating to a predetermined temperature the substrate that has been exposed to the atmosphere of the mixed gas.

According to the above program, effects as for the seventh aspect can be achieved.

The above and other objects, features, and advantages will become more apparent from the following detailed description taken in conjunction with the accompanying drawings.

## BRIEF DESCRIPTION OF THE DRAWINGS

FIG. 1 is a plan view schematically showing the construction of a substrate processing apparatus to which is applied a method of surface processing a substrate;

FIGS. 2A and 2B are sectional views of a second processing unit appearing in FIG. 1; specifically:

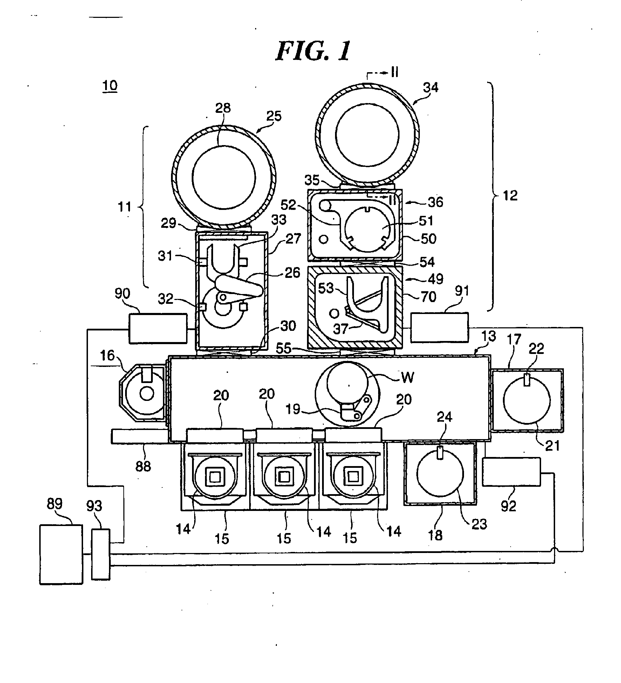

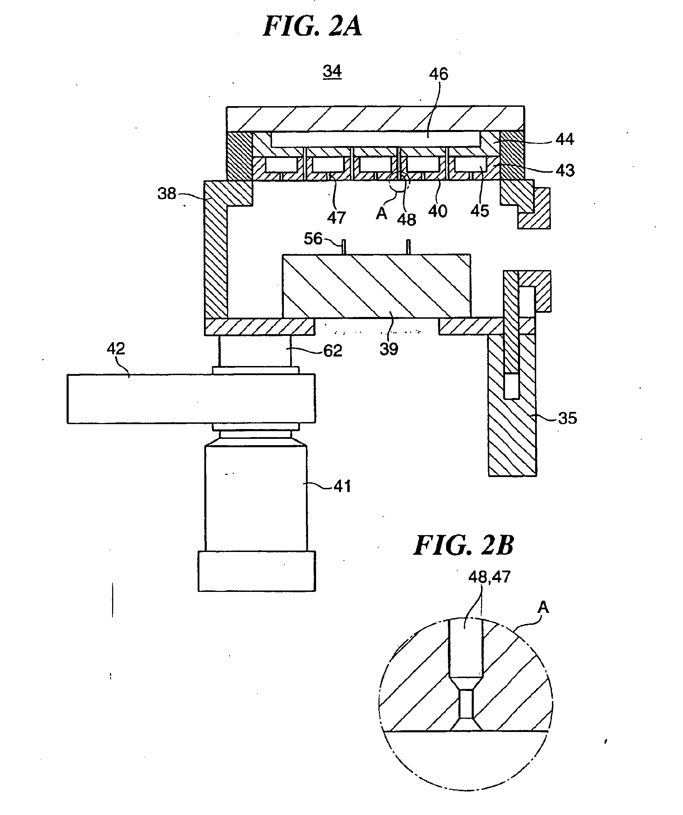

FIG. 2A is a sectional view taken along line II-II in FIG. 1; and

FIG. 2B is an enlarged view of a portion A shown in FIG. 2A;

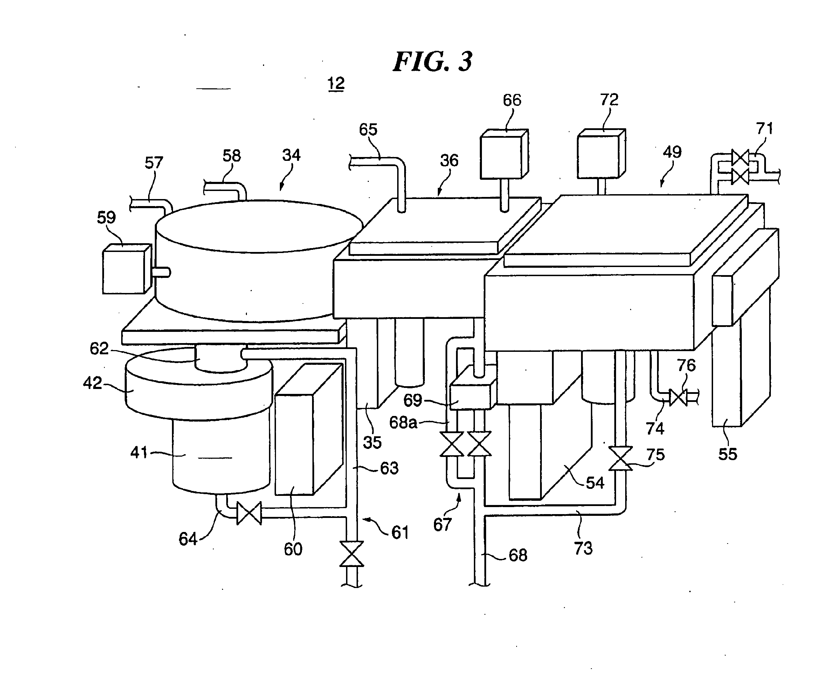

FIG. 3 is a perspective view schematically showing the construction of a second process ship appearing in FIG. 1;

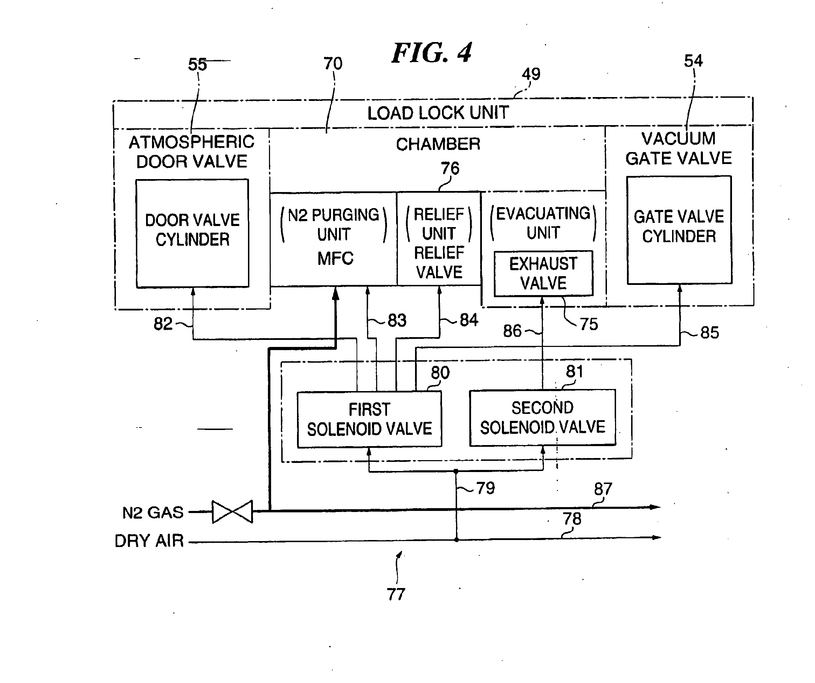

FIG. 4 is a diagram schematically showing the construction of a unit-driving dry air supply system for a second load lock unit appearing in FIG. 3;

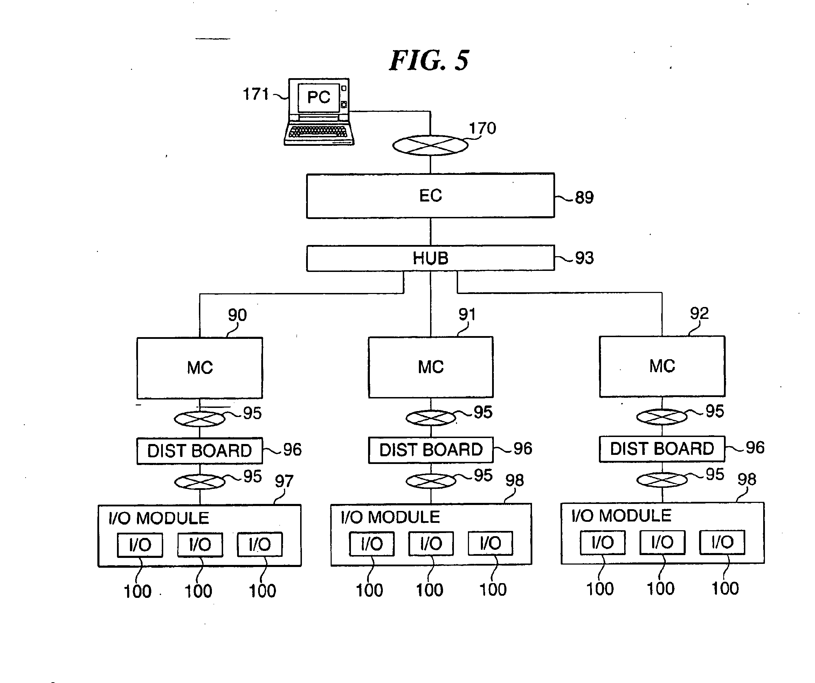

FIG. 5 is a diagram schematically showing the construction of a system controller for the substrate processing apparatus shown in FIG. 1;

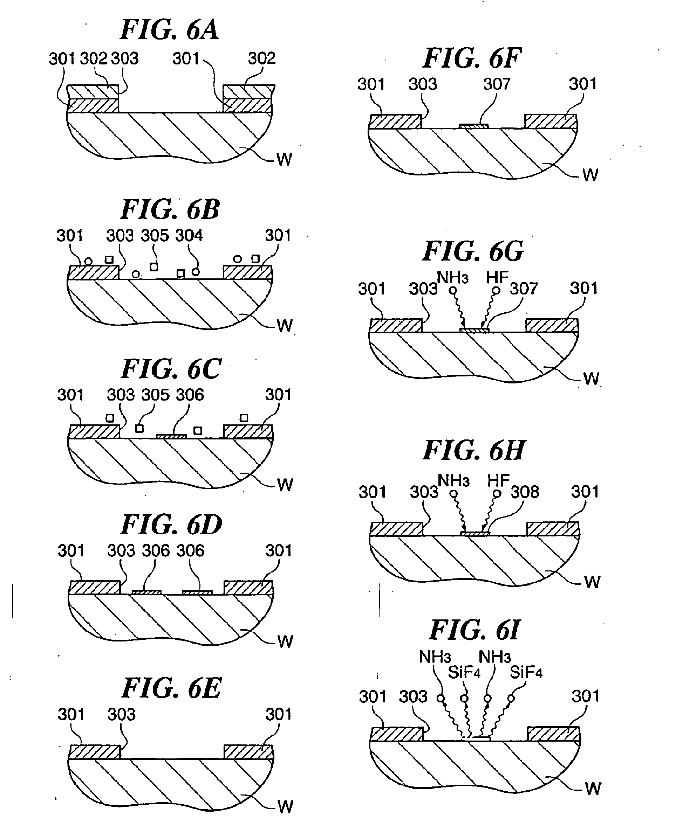

FIGS. 6A to 6I constitute a process diagram showing a method of surface processing a substrate;

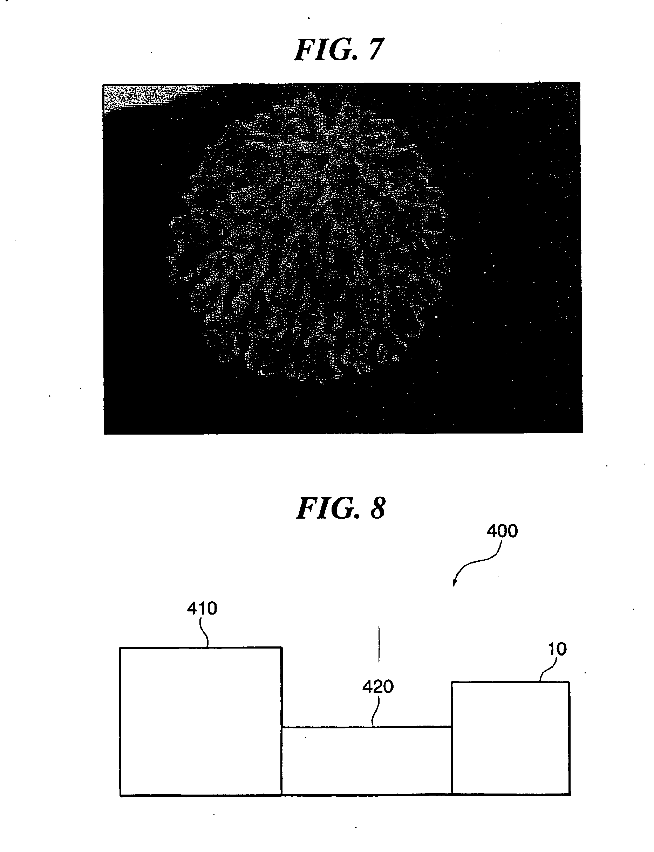

FIG. 7 is an enlarged view showing a watermark formed on a hydrophobic surface of a wafer;

FIG. 8 is a view schematically showing the construction of a substrate cleaning system, which is a first variation of the substrate processing apparatus to which is applied the method of surface processing a substrate;

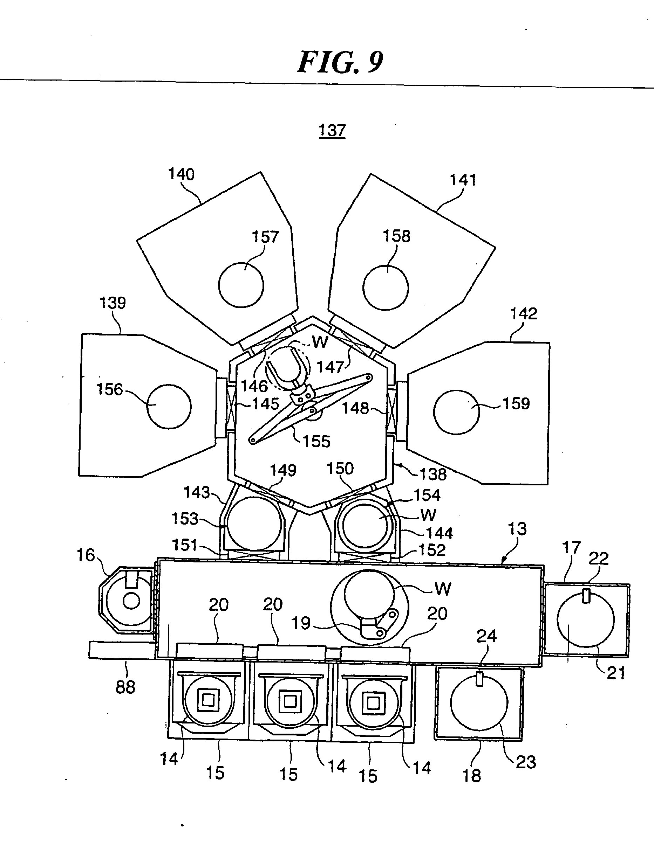

FIG. 9 is a plan view schematically showing the construction of a second variation of the substrate processing apparatus to which is applied the method of surface processing a substrate; and

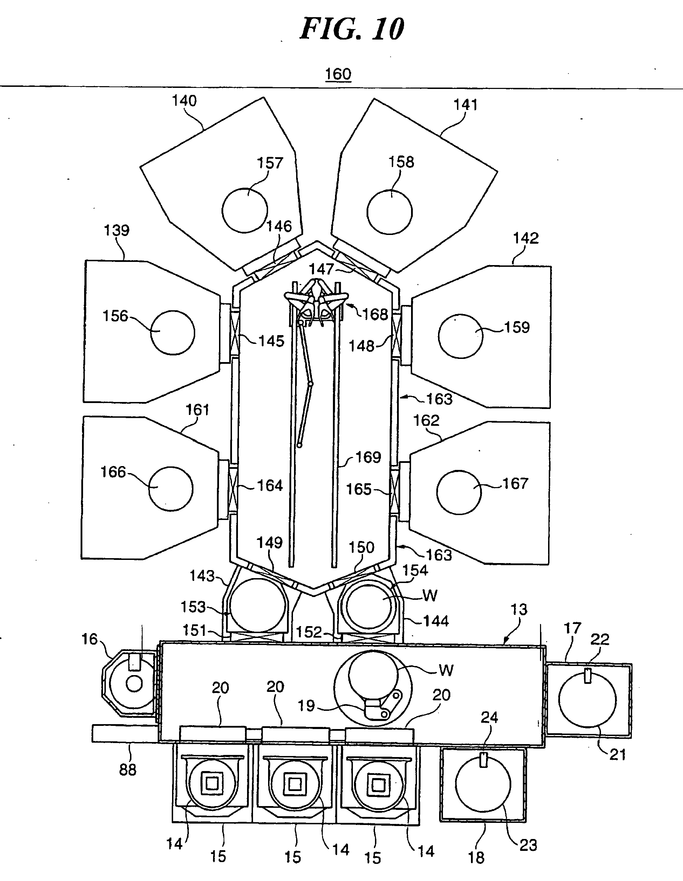

FIG. 10 is a plan view schematically showing the construction of a third variation of the substrate processing apparatus to which is applied the method of surface processing a substrate.

DETAILED DESCRIPTION

The present invention as claimed in claims 1, 18 will now be described in detail with reference to the drawings showing examples thereof.

First, a method of surface processing a substrate according to an embodiment of the present invention will be described.

FIG. 1 is a plan view schematically showing the construction of a substrate processing apparatus to which is applied the method of surface processing a substrate according to the present embodiment.

As described below, the substrate processing apparatus implements COR cleaning processing as post-processing in cleaning processing for removing contamination attached to a surface, or native oxide formed on the surface, of an electronic device wafer in which contact holes or the like have been formed.

As shown in FIG. 1, the substrate processing apparatus 10 is comprised of a first process ship 11 for carrying out reactive ion etching (hereinafter referred to as "RIE") processing on electronic device wafers (hereinafter referred to merely as "wafers") (substrates) W, a second process ship 12 that is disposed parallel to the first process ship 11 and is for carrying out COR (chemical oxide removal) processing and PHT (post heat treatment) processing, described below, on the wafers W, and a loader unit 13, which is a rectangular common transfer chamber to which each of the first process ship 11 and the second process ship 12 is connected.

In addition to the first process ship 11 and the second process ship 12, the loader unit 13 has connected thereto three FOUP mounting stages 15 on each of which is mounted a FOUP (front opening unified pod) 14, which is a container housing twenty-five of the wafers W, an orienter 16 that carries out pre-alignment of the position of each wafer W transferred out from a FOUP 14, and first and second IMS's 17 and 18 (Integrated Metrology Systems, made by Therma-Wave, Inc.) for measuring the surface state of each wafer W.

The first process ship 11 and the second process ship 12 are each connected to a side wall of the loader unit 13 in a longitudinal direction of the loader unit 13, disposed facing the three FOUP mounting stages 15 with the loader unit 13 therebetween. The orienter 16 is disposed at one end of the loader unit 13 in the longitudinal direction of the loader unit 13. The first IMS 17 is disposed at the other end of the loader unit 13 in the longitudinal direction of the loader unit 13. The second IMS 18 is disposed alongside the three FOUP mounting stages 15.

A SCARA-type dual arm transfer arm mechanism 19 for transferring the wafers W is disposed inside the loader unit 13, and three loading ports 20 through which the wafers W are introduced into the loader unit 13 are disposed in a side wall of the loader unit 13 in correspondence with the FOUP mounting stages 15. The transfer arm mechanism 19 takes a wafer W out from a FOUP 14 mounted on a FOUP mounting stage 15 through the corresponding loading port 20, and transfers the removed wafer W into and out of the first process ship 11, the second process ship 12, the orienter 16, the first IMS 17, and the second IMS 18.

The first IMS 17 is an optical monitor having a mounting stage 21 on which is mounted a wafer W that has been transferred into the first IMS 17, and an optical sensor 22 that is directed at the wafer W mounted on the mounting stage 21. The first IMS 17 measures the surface shape of the wafer W, for example the thickness of a surface layer, and CD (critical dimension) values of wiring grooves, gate electrodes and so on. Like the first IMS 17, the second IMS 18 is also an optical monitor, and has a mounting stage 23 and an optical sensor 24. The second IMS 18 measures the number of particles on the surface of each wafer W.

The first process ship 11 has a first processing unit 25 as a first vacuum processing chamber in which the RIE processing is carried out on each wafer W, and a first load lock unit 27 containing a link-type single pick-type first transfer arm 26 for transferring each wafer W into and out of the first processing unit 25.

The first processing unit 25 has a cylindrical processing chamber, and an upper electrode and a lower electrode disposed in the chamber. The distance between the upper electrode and the lower electrode is set to an appropriate value for carrying out the RIE processing on each wafer W. Moreover, the lower electrode has in a top portion thereof an ESC (electrostatic chuck) 28 for chucking the wafer W thereto using a Coulomb force or the like.

In the first processing unit 25, a processing gas is introduced into the chamber and an electric field is generated between the upper electrode and the lower electrode, whereby the introduced processing gas is turned into plasma so as to produce ions and radicals. The wafer W is subjected to the RIE processing by the ions and radicals.

In the first process ship 11, the internal pressure of the first processing unit 25 is held at vacuum, whereas the internal pressure of the loader unit 13 is held at atmospheric pressure. The first load lock unit 27 is thus provided with a vacuum gate valve 29 in a connecting part between the first load lock unit 27 and the first processing unit 25, and an atmospheric gate valve 30 in a connecting part between the first load lock unit 27 and the loader unit 13, whereby the first load lock unit 27 is constructed as a preliminary vacuum transfer chamber whose internal pressure can be adjusted.

Within the first load lock unit 27, the first transfer arm 26 is disposed in an approximately central portion of the first load lock unit 27; first buffers 31 are disposed toward the first processing unit 25 with respect to the first transfer arm 26, and second buffers 32 are disposed toward the loader unit 13 with respect to the first transfer arm 26. The first buffers 31 and the second buffers 32 are disposed above a track along which a supporting portion (pick) 33 moves, the supporting portion 33 being disposed at the distal end of the first transfer arm 26 and being for supporting each wafer W. After having being subjected to the RIE processing, each wafer W is temporarily laid by above the track of the supporting portion 33, whereby swapping over of the wafer W that has been subjected to the RIE processing and a wafer W yet to be subjected to the RIE processing can be carried out smoothly in the first processing unit 25.

The second process ship 12 has a second processing unit 34 as a second vacuum processing chamber in which the COR processing is carried out on each wafer W, a third processing unit 36 as a third vacuum processing chamber that is connected to the second processing unit 34 via a vacuum gate valve 35 and in which the PHT processing is carried out on each wafer W, and a second load lock unit 49 containing a link-type single-pick type second transfer arm 37 for transferring each wafer W into and out of the second processing unit 34 and the third processing unit 36.

FIGS. 2A and 2B are sectional views of the second processing unit 34 appearing in FIG. 1; specifically, FIG. 2A is a sectional view taken along line II-II in FIG. 1, and FIG. 2B is an enlarged view of a portion A shown in FIG. 2A.

As shown in FIG. 2A, the second processing unit 34 has a cylindrical processing chamber (chamber) 38, an ESC 39 as a wafer W mounting stage disposed in the chamber 38, a shower head 40 disposed above the chamber 38, a TMP (turbo molecular pump) 41 for exhausting gas out from the chamber 38, and an APC (automatic pressure control) valve 42 that is a variable butterfly valve disposed between the chamber 38 and the TMP 41 for controlling the pressure in the chamber 38.

The ESC 39 has therein an electrode plate (not shown) to which a DC voltage is applied. A wafer W is attracted to and held on the ESC 39 through a Johnsen-Rahbek force or a Coulomb force generated by the DC voltage. Moreover, the ESC 39 also has a coolant chamber (not shown) as a temperature adjusting mechanism. A coolant, for example cooling water or a Galden fluid, at a predetermined temperature is circulated through the coolant chamber. A processing temperature of the wafer W held on an upper surface of the ESC 39 is controlled through the temperature of the coolant. Furthermore, the ESC 39 also has a heat-transmitting gas supply system (not shown) that supplies a heat-transmitting gas (helium gas) uniformly between the upper surface of the ESC 39 and a rear surface of the wafer. The heat-transmitting gas carries out heat exchange between the wafer and the ESC 39, which is held at a desired specified temperature by the coolant during the COR processing, thus cooling the wafer efficiently and uniformly.

Moreover, the ESC 39 has a plurality of pusher pins 56 as lifting pins that can be made to project out from the upper surface of the ESC 39. The pusher pins 56 are housed inside the ESC 39 when a wafer W is attracted to and held on the ESC 39, and are made to project out from the upper surface of the ESC 39 so as to lift the wafer W up when the wafer W is to be transferred out from the chamber 38 after having been subjected to the COR processing.

The shower head 40 has a two-layer structure comprised of a lower layer portion 43 and an upper layer portion 44. The lower layer portion 43 has first buffer chambers 45 therein, and the upper layer portion 44 has a second buffer chamber 46 therein. The first buffer chambers 45 and the second buffer chamber 46 are communicated with the chamber 38 via gas-passing holes 47 and 48 respectively. That is, the shower head 40 is comprised of two plate-shaped members (the lower layer portion 43 and the upper layer portion 44) that are disposed on one another and have therein internal channels leading into the chamber 38 for gas supplied into the first buffer chambers 45 and the second buffer chamber 46.

When carrying out the COR processing on a wafer W, $NH_3$ (ammonia) gas is supplied into the first buffer chambers 45 from an ammonia gas supply pipe 57, described below, and the supplied ammonia gas is then supplied via the gas-passing holes 47 into the chamber 38, and moreover HF (hydrogen fluoride) gas is supplied into the second buffer chamber 46 from a hydrogen fluoride gas supply pipe 58, described below, and the supplied hydrogen fluoride gas is then supplied via the gas-passing holes 48 into the chamber 38.

Moreover, the shower head 40 also has a heater, for example a heating element, (not shown) built therein. The heating element is preferably disposed on the upper layer portion 44, for controlling the temperature of the hydrogen fluoride gas in the second buffer chamber 46.

Moreover, a portion of each of the gas-passing holes 47 and 48 where the gas-passing hole 47 or 48 opens out into the chamber 38 is formed so as to widen out toward an end thereof as shown in FIG. 2B. As a result, the ammonia gas and the hydrogen fluoride gas can be made to diffuse through the chamber 38 efficiently. Furthermore, each of the gas-passing holes 47 and 48 has a cross-sectional shape having a constriction therein. As a result, any deposit produced in the chamber 38 can be prevented from flowing back into the gas-passing holes 47 and 48, and thus the first buffer chambers 45 and the second buffer chamber 46. Alternatively, the gas-passing holes 47 and 48 may each have a spiral shape.

In the second processing unit 34, the COR processing is carried out on a wafer W by adjusting the pressure in the chamber 38 and the volumetric flow rate ratio between the ammonia gas and the hydrogen fluoride gas. Moreover, the second processing unit 34 is designed such that the ammonia gas and the hydrogen fluoride gas first mix with one another in the chamber 38 (post-mixing design), and hence the two gases are prevented from mixing together until they are introduced into the chamber 38, whereby the hydrogen fluoride gas and the ammonia gas are prevented from reacting with one another before being introduced into the chamber 38.

Moreover, in the second processing unit 34, a heater, for example a heating element, (not shown) is built into a side wall of the chamber 38, whereby the temperature of the atmosphere in the chamber 38 can be prevented from decreasing. As a result, the reproducibility of the COR processing can be improved. Moreover, the heating element in the side wall also controls the temperature of the side wall, whereby by-products formed in the chamber 38 can be prevented from becoming attached to the inside of the side wall.

Returning to FIG. 1, the third processing unit 36 has a box-shaped processing chamber (chamber) 50, a stage heater 51 as a wafer W mounting stage disposed in the chamber 50, a buffer arm 52 that is disposed around the stage heater 51 and lifts up a wafer W mounted on the stage heater 51, and a PHT chamber lid (not shown) as an openable/closable lid that isolates the interior of the chamber from the external atmosphere.

The stage heater 51 is made of aluminum having an oxide film formed on a surface thereof, and heats the wafer W mounted thereon up to a predetermined temperature through heating wires or the like built therein. Specifically, the stage heater 51 directly heats the wafer W mounted thereon up to 100 to 200°C, preferably approximately 135°C, over at least 1 minute.

The PHT chamber lid has a sheet heater made of silicone rubber disposed thereon. Moreover, a cartridge heater (not shown) is built into a side wall of the chamber 50. The cartridge heater controls the wall surface temperature of the side wall of the chamber 50 to a temperature in a range of 25 to 80°C. As a result, by-products are prevented from becoming attached to the side wall of the chamber 50, whereby particles due to such attached by-products are prevented from arising, and hence the time period between one cleaning and the next of the chamber 50 can be extended. Moreover, an outer periphery of the chamber 50 is covered by a heat shield.

Instead of the sheet heater described above, a UV (ultraviolet) radiation heater may alternatively be used as the heater for heating the wafer W from above. An example of such a UV heater is a UV lamp that emits UV of wavelength 190 to 400 nm.

After being subjected to the COR processing, each wafer W is temporarily laid by above a track of a supporting portion 53 of the second transfer arm 37 by the buffer arm 52, whereby swapping over of wafers W in the second processing unit 34 and the third processing unit 36 can be carried out smoothly.

In the third processing unit 36, the PHT processing is carried out on each wafer W by adjusting the temperature of the wafer W.

The second load lock unit 49 has a box-shaped transfer chamber (chamber) 70 containing the second transfer arm 37. The internal pressure of each of the second processing unit 34 and the third processing unit 36 is held at vacuum, whereas the internal pressure of the loader unit 13 is held at atmospheric pressure. The second load lock unit 49 is thus provided with a vacuum gate valve 54 in a connecting part between the second load lock unit 49 and the third processing unit 36, and an atmospheric door valve 55 in a connecting part between the second load lock unit 49 and the loader unit 13, whereby the second load lock unit 49 is constructed as a preliminary vacuum transfer chamber whose internal pressure can be adjusted.

FIG. 3 is a perspective view schematically showing the construction of the second process ship 12 appearing in FIG. 1.

As shown in FIG. 3, the second processing unit 34 has the ammonia gas supply pipe 57 for supplying ammonia gas into the first buffer chambers 45, the hydrogen fluoride gas supply pipe 58 for supplying hydrogen fluoride gas into the second buffer chamber 46, a pressure gauge 59 for measuring the pressure in the chamber 38, and a chiller unit 60 that supplies a coolant into the cooling system provided in the ESC 39.

The ammonia gas supply pipe 57 has provided therein an MFC (mass flow controller) (not shown) for adjusting the flow rate of the ammonia gas supplied into the first buffer chambers 45, and the hydrogen fluoride gas supply pipe 58 has provided therein an MFC (not shown) for adjusting the flow rate of the hydrogen fluoride gas supplied into the second buffer chamber 46. The MFC in the ammonia gas supply pipe 57 and the MFC in the hydrogen fluoride gas supply pipe 58 operate collaboratively so as to adjust the volumetric flow rate ratio between the ammonia gas and the hydrogen fluoride gas supplied into the chamber 38.

Moreover, a second processing unit exhaust system 61 connected to a DP (dry pump) (not shown) is disposed below the second processing unit 34. The second processing unit exhaust system 61 is for exhausting gas out from the chamber 38, and has an exhaust pipe 63 that is communicated with an exhaust duct 62 provided between the chamber 38 and the APC valve 42, and an exhaust pipe 64 connected below (i.e. on the exhaust side) of the TMP 41. The exhaust pipe 64 is connected to the exhaust pipe 63 upstream of the DP.

The third processing unit 36 has a nitrogen gas supply pipe 65 for supplying nitrogen ($N_2$) gas into the chamber 50, a pressure gauge 66 for measuring the pressure in the chamber 50, and a third processing unit exhaust system 67 for exhausting the nitrogen gas out from the chamber 50.

The nitrogen gas supply pipe 65 has provided therein an MFC (not shown) for adjusting the flow rate of the nitrogen gas supplied into the chamber 50. The third processing unit exhaust system 67 has a main exhaust pipe 68 that is communicated with the chamber 50 and is connected to a DP, an APC valve 69 that is disposed part way along the main exhaust pipe 68, and an auxiliary exhaust pipe 68a that branches off from the main exhaust pipe 68 so as to circumvent the APC valve 69 and is connected to the main exhaust pipe 68 upstream of the DP. The APC valve 69 controls the pressure in the chamber 50.

The second load lock unit 49 has a nitrogen gas supply pipe 71 for supplying nitrogen gas into the chamber 70, a pressure gauge 72 for measuring the pressure in the chamber 70, a second load lock unit exhaust system 73 for exhausting the nitrogen gas out from the chamber 70, and an external atmosphere communicating pipe 74 for releasing the interior of the chamber 70 to the external atmosphere.

The nitrogen gas supply pipe 71 has provided therein an MFC (not shown) for adjusting the flow rate of the nitrogen gas supplied into the chamber 70. The second load lock unit exhaust system 73 is comprised of a single exhaust pipe, which is communicated with the chamber 70 and is connected to the main exhaust pipe 68 of the third processing unit exhaust system 67 upstream of the DP. Moreover, the second load lock unit exhaust system 73 has an openable/closable exhaust valve 75 therein, and the external atmosphere communicating pipe 74 has an openable/closable relief valve 76 therein. The exhaust valve 75 and the relief valve 76 are operated collaboratively so as to adjust the pressure in the chamber 70 to any pressure from atmospheric pressure to a desired degree of vacuum.

FIG. 4 is a diagram schematically showing the construction of a unit-driving dry air supply system for the second load lock unit 49 appearing in FIG. 3.

As shown in FIG. 4, dry air from the unit-driving dry air supply system 77 for the second load lock unit 49 is supplied to a door valve cylinder for driving a sliding door of the atmospheric door valve 55, the MFC in the nitrogen gas supply pipe 71 as an N₂ purging unit, the relief valve 76 in the external atmosphere communicating pipe 74 as a relief unit for releasing the interior of the chamber 70 to the external atmosphere, the exhaust valve 75 in the second load lock unit exhaust system 73 as an evacuating unit, and a gate valve cylinder for driving a sliding gate of the vacuum gate valve 54.

The unit-driving dry air supply system 77 has an auxiliary dry air supply pipe 79 that branches off from a main dry air supply pipe 78 of the second process ship 12, and a first solenoid valve 80 and a second solenoid valve 81 that are connected to the auxiliary dry air supply pipe 79.

The first solenoid valve 80 is connected respectively to the door valve cylinder, the MFC, the relief valve 76, and the gate valve cylinder by dry air supply pipes 82, 83, 84, and 85, and controls operation of these elements by controlling the amount of dry air supplied thereto. Moreover, the second solenoid valve 81 is connected to the exhaust valve 75 by a dry air supply pipe 86, and controls operation of the exhaust valve 75 by controlling the amount of dry air supplied to the exhaust valve 75.

The MFC in the nitrogen gas supply pipe 71 is also connected to a nitrogen (N₂) gas supply system 87.

The second processing unit 34 and the third processing unit 36 also each has a unit-driving dry air supply system having a similar construction to the unit-driving dry air supply system 77 for the second load lock unit 49 described above.

Returning to FIG. 1, the substrate processing apparatus 10 has a system controller for controlling operations of the first process ship 11, the second process ship 12 and the loader unit 13, and an operation controller 88 that is disposed at one end of the loader unit 13 in the longitudinal direction of the loader unit 13.

The operation controller 88 has a display section comprised of, for example, an LCD (liquid crystal display), for displaying the state of operation of the component elements of the substrate processing apparatus 10.

Moreover, as shown in FIG. 5, the system controller is comprised of an EC (equipment controller) 89, three MC's (module controllers) 90, 91 and 92, and a switching hub 93 that connects the EC 89 to each of the MC's. The EC 89 of the system controller is connected via a LAN (local area network) 170 to a PC 171, which is an MES (manufacturing execution system) that carries out overall control of the manufacturing processes in the manufacturing plant in which the substrate processing apparatus 10 is installed. In collaboration with the system controller, the MES feeds back real-time data on the processes in the manufacturing plant to a basic work system (not shown), and makes decisions relating to the processes in view of the overall load on the manufacturing plant and so on.

The EC 89 is a master controller (main controller) that controls the MC's and carries out overall control of the operation of the substrate processing apparatus 10. The EC 89 has a CPU, a RAM, an HDD and so on. The CPU sends control signals to the MC's in accordance with programs corresponding to wafer W processing methods, i.e. recipes, specified by a user using the operation controller 88, thus controlling the operations of the first process ship 11, the second process ship 12 and the loader unit 13.

The switching hub 93 selects at least one connection among the connections between the EC 89 and the MC's in accordance with the control signals from the EC 89.

The MC's 90, 91 and 92 are slave controllers (auxiliary controllers) that control the operations of the first process ship 11, the second process ship 12, and the loader unit 13 respectively. Each of the MC's is connected respectively to an I/O (input/output) module 97, 98 or 99 through a DIST (distribution) board 96 via a GHOST network 95. Each GHOST network 95 is a network that is realized through an LSI known as a GHOST (general high-speed optimum scalable transceiver) on an MC board of the corresponding MC. A maximum of 31 I/O modules can be connected to each GHOST network 95; with respect to the GHOST network 95, the MC is the master, and the I/O modules are slaves.

The I/O module 98 is comprised of a plurality of I/O units 100 that are connected to component elements (hereinafter referred to as "end devices") of the second process ship 12, and transmits control signals to the end devices and output signals from the end devices. Examples of the end devices connected to the I/O units 100 of the I/O module 98 are: in the second processing unit 34, the MFC in the ammonia gas supply pipe 57, the MFC in the hydrogen fluoride gas supply pipe 58, the pressure gauge 59, and the APC valve 42; in the third processing unit 36, the MFC in the nitrogen gas supply pipe 65, the pressure gauge 66, the APC valve 69, the buffer arm 52, and the stage heater 51; in the second load lock unit 49, the MFC in the nitrogen gas supply pipe 71, the pressure gauge 72, and the second transfer arm 37; and in the unit-driving dry air supply system 77, the first solenoid valve 80, and the second solenoid valve 81.

Each of the I/O modules 97 and 99 has a similar construction to the I/O module 98. Moreover, the connection between the I/O module 97 and the MC 90 for the first process ship 11, and the connection between the I/O module 99 and the MC 92 for the loader unit 13 are constructed similarly to the connection between the I/O module 98 and the MC 91 described above, and hence description thereof is omitted.

Each GHOST network 95 is also connected to an I/O board (not shown) that controls input/output of digital signals, analog signals and serial signals to/from the I/O units 100.

In the substrate processing apparatus 10, when carrying out the COR processing on a wafer W, the CPU of the EC 89 implements the COR processing in the second processing unit 34 by sending control signals to desired end devices via the switching hub 93, the MC 91, the GHOST network 95, and the I/O units 100 of the I/O module 98, in accordance with a program corresponding to a recipe for the COR processing.

Specifically, the CPU sends control signals to the MFC in the ammonia gas supply pipe 57 and the MFC in the hydrogen fluoride gas supply pipe 58 so as to adjust the volumetric flow rate ratio between the ammonia gas and the hydrogen fluoride gas in the chamber 38 to a desired value, and sends control signals to the TMP 41 and the APC valve 42 so as to adjust the pressure in the chamber 38 to a desired value. Moreover, at this time, the pressure gauge 59 sends the value of the pressure in the chamber 38 to the CPU of the EC 89 in the form of an output signal, and the CPU determines control parameters for the MFC in the ammonia gas supply pipe 57, the MFC in the hydrogen fluoride gas supply pipe 58, the APC valve 42, and the TMP 41 based on the sent value of the pressure in the chamber 38.

Moreover, when carrying out the PHT processing on a wafer W, the CPU of the EC 89 implements the PHT processing in the third processing unit 36 by sending control signals to desired end devices in accordance with a program corresponding to a recipe for the PHT processing.

Specifically, the CPU sends control signals to the MFC in the nitrogen gas supply pipe 65, and the APC valve 69 so as to adjust the pressure in the chamber 50 to a desired value, and sends control signals to the stage heater 51 so as to adjust the temperature of the wafer W to a desired temperature. Moreover, at this time, the pressure gauge 66 sends the value of the pressure in the chamber 50 to the CPU of the EC 89 in the form of an output signal, and the CPU determines control parameters for the APC valve 69, and the MFC in the nitrogen gas supply pipe 65 based on the sent value of the pressure in the chamber 50.

According to the system controller shown in FIG. 5, the plurality of end devices are not directly connected to the EC 89, but rather the I/O units 100 which are connected to the plurality of end devices are modularized to form the I/O modules, and each I/O module is connected to the EC 89 via an MC and the switching hub 93. As a result, the communication system can be simplified.

Moreover, each of the control signals sent by the CPU of the EC 89 contains the address of the I/O unit 100 connected to the desired end device, and the address of the I/O module containing that I/O unit 100. The switching hub 93 thus refers to the address of the I/O module in the control signal, and then the GHOST of the appropriate MC refers to the address of the I/O unit 100 in the control signal, whereby the need for the switching hub 93 or the MC to ask the CPU for the destination of the control signal can be eliminated, and hence smoother transmission of the control signals can be realized.

After contact holes for source/drain contact or the like have been fabricated in an insulating film formed on a surface of a wafer W, it is necessary to clean the wafer W before subsequent processing can be carried out on the wafer W. As described earlier, in a conventional cleaning method, watermarks are formed on the surface of the wafer W through spin drying, whereas carbon-based organic matter remains on the surface of the wafer W in the case of IPA drying. Such watermarks on the surface of the wafer W can cause various problems in an electronic device manufactured from the wafer W, and hence must be removed.

In the method of surface processing a substrate according to the present example, to achieve this, the wafer W is subjected to COR processing and PHT processing as post-processing in the cleaning process.

The COR processing is processing in which an oxide film on an object to be processed (the substrate) is made to undergo chemical reaction with gas molecules to produce a product, and the PHT processing is processing in which the object to be processed that has been subjected to the COR processing is heated so as to vaporize / thermally oxidize the product that has been produced on the object to be processed through the chemical reaction in the COR processing, thus removing the product from the object to be processed. As described earlier, the COR processing and the PHT processing are (particularly the COR processing is) processing in which the oxide film on the object to be processed is removed without using plasma and without using water, and hence are categorized as plasma-less etching or dry cleaning.

In the method of surface processing a substrate according to the present example, ammonia gas and hydrogen fluoride gas are used as the gas. Here, the hydrogen fluoride gas promotes corrosion of an $SiO_2$ layer, and the ammonia gas is involved in synthesis of a reaction by-product for restricting, and ultimately stopping, the reaction between the oxide film and the hydrogen fluoride gas as required. Specifically, the following chemical reactions are used in the COR processing and the PHT processing, whereby silicon oxide ($SiO_2$) watermarks formed on a hydrophobic surface of a wafer W are removed so as to clean the wafer W.

(COR PROCESSING)

$$SiO_2 + 4HF \rightarrow SiF_4 + 2H_2O\uparrow$$

$$SiF_4 + 2NH_3 + 2HF \rightarrow (NH_4)_2SiF_6$$

(PHT PROCESSING)

$$(NH_4)_2SiF_6 \rightarrow SiF_4\uparrow + 2NH_3\uparrow + 2HF\uparrow$$

It has been found by the present inventors that the COR processing and PHT processing using the above chemical reactions exhibit the following characteristics. Incidentally, small amounts of $N_2$ and $H_2$ are also produced in the PHT processing.

1) Selectivity (removal rate) for thermal oxide film is high

Specifically, according to the COR processing and PHT processing, the selectivity for a thermal oxide film is high, whereas the selectivity for polysilicon is low. A surface layer of an $SiO_2$ insulating film, which is a thermal oxide film, or a pseudo-$SiO_2$ layer, which has similar properties to such an $SiO_2$ film, or native oxide or watermarks on a silicon surface layer can thus be removed efficiently. Note that the above pseudo-$SiO_2$ layer is also known as an "altered layer" or a "sacrificial layer".

2) Rate of growth of native oxide on surface of insulating film from which surface layer or pseudo-$SiO_2$ layer has been removed is slow

Specifically, the time taken for growth of a native oxide film of thickness 3 Å on the surface of a wafer W that has been revealed by wet etching is 10 minutes, whereas the time taken for growth of a native oxide film of thickness 3 Å on the surface of a wafer W that has been revealed by the COR processing and the PHT processing is over 2 hours. There is thus no watermark formation in the electronic device cleaning process, and moreover growth of native oxide over time after the cleaning process can be suppressed, and hence the reliability of the electronic device can be improved.

3) Reaction proceeds in dry environment

Specifically, water is not used in the reaction in the COR processing, and moreover even though water molecules are produced through the COR processing as described earlier, because the COR processing is carried out in a substantially vacuum state as described below, the water molecules are produced in a gaseous state. There is thus no attachment of water molecules in a liquid state to the wafer W, and thus there is no formation of watermarks or the like on the surface of the wafer W in the COR processing. Moreover, the PHT processing is carried out at a high temperature as described below, and hence there is no formation of watermarks or the like on the surface of the wafer W in the PHT processing. Furthermore, there are no OH groups on the revealed surface of the wafer W. The surface of the wafer W thus does not become hydrophilic, and hence the surface does not absorb moisture. A decrease in electronic device wiring reliability can thus be prevented.

4) Amount produced of product (complex) levels off after a certain time has elapsed

Specifically, once a certain time has elapsed, even if the watermarks continue to be exposed to the mixed gas of ammonia gas and hydrogen fluoride gas beyond this, there is no further increase in the amount produced of the product. Moreover, the amount produced of the product is determined by parameters of the mixed gas such as the pressure of the mixed gas and the volumetric flow rate ratio. Control of the amount removed of the watermarks can thus be carried out easily. In the COR processing, the hydrogen fluoride gas is a reacting gas, and the ammonia gas is a corroding gas. In the COR processing, the ammonia ($NH_3$) neutralizes the hydrogen fluoride (HF), thus inhibiting the progress of the reaction between the hydrogen fluoride gas and the silicon oxide ($SiO_2$). The amount removed of the watermarks can thus be easily controlled by, for example, adjusting the volumetric flow rate ratio between the ammonia gas and the hydrogen fluoride gas.

5) Very little particle formation

Specifically, even upon implementing watermark removal for 2000 wafers W in the second processing unit 34 and the third processing unit 36, hardly any attachment of particles to the inner wall of the chamber 38 or the chamber 50 is observed. Problems due to particles such as short-circuiting of the electronic device wiring thus do not occur, and hence the reliability of the electronic device can be improved. FIGS. 6A to 6I constitute a process diagram showing the method of surface processing a substrate according to the present example.

In the present example, a wafer W is cleaned after contact holes 303 (connecting holes) for source/drain contact or the like have been fabricated using a resist film 302 (photoresist layer) in an insulating film 301 (first layer) formed on a surface of the wafer W (see FIG. 6A).

In the method shown in FIGS. 6A to 6I, using a pre-cleaning apparatus (not shown) for carrying out pre-processing in a cleaning process in the method of surface processing a substrate according to the present example, first, wet cleaning, for example cleaning using a mixed liquid comprised of $H_2SO_4$ (sulfuric acid) and an $H_2O_2$ (hydrogen peroxide) aqueous solution (SPM cleaning), is carried out so as to remove the resist film 302 formed on the wafer W (see FIG. 6B). Through the wet cleaning, particles 304 and contamination such as metal contamination 305 become attached to the wafer W. The removal of the resist film 302 may alternatively be carried out using plasma ashing instead of the wet cleaning. In this case, ashing residue becomes attached to the wafer W as contamination.

Next, SC1 cleaning is carried out so as to remove the particles 304 (see FIG. 6C). The SC1 cleaning is carried out over, for example, not more than 5 minutes. As described earlier, SC1 is a mixed liquid of an $NH_4OH$ (ammonia) aqueous solution and an $H_2O_2$ (hydrogen peroxide) aqueous solution, and hence native oxide 306, which is a hydrophilic layer, is formed on the silicon surface in the contact holes 303 in the wafer W through the SC1 cleaning. Due to the native oxide 306 being formed on the surface of the wafer W through the SC1 cleaning, the surface of the wafer W thus becomes hydrophilic. The native oxide 306 is a silicon native oxide film which is an oxygentermination on silicon surface in an oxidized state that grows in the liquid chemical.

Next, the SC1 containing the removed particles 304 is washed off by cleaning with pure water (rinsing liquid), and then SC2 cleaning is carried out so as to remove the metal contamination 305 (see FIG. 6D). The SC2 cleaning is carried out over, for example, not more than 5 minutes. As described earlier, SC2 is a mixed liquid of HCl (hydrochloric acid) and an $H_2O_2$ (hydrogen peroxide) aqueous solution, and hence native oxide 306, which is a hydrophilic layer, is formed on the silicon surface in the contact holes 303 in the wafer W through the SC2 cleaning. Due to the native oxide 306 being formed on the surface of the wafer W through the SC2 cleaning, as for the SC1 cleaning, the surface of the wafer W thus becomes hydrophilic.

Next, the SC2 containing the removed metal contamination 305 is washed off by cleaning with pure water, and then DHF cleaning is carried out so as to remove the native oxide 306 that has arisen on the surface of the wafer W (see FIG. 6E). After the DHF cleaning, the DHF containing the removed native oxide 306 is washed off by cleaning with pure water, and then spin drying is carried out. As described earlier, the surface of the wafer W becomes hydrophobic through the DHF cleaning, and hence when the wafer W is pulled out from the cleaning tank, water droplets remain on the surface of the wafer W, and furthermore dissolved oxygen in the water droplets remaining on the Si wafer surface reacts with the wafer surface to form $SiO_2$, and the $SiO_2$ further reacts with residual HF to form $H_2SiF_6$. Upon the spin drying being carried out in this state, the $H_2SiF_6$ remains as watermarks 307, which is silicon oxide ($SiO_2$), as shown in FIG. 7, i.e. deposit, on the hydrophobic surface after the drying (see FIG. 6F). Moreover, because spin drying is carried out, IPA molecules (carbon-based organic matter) do not remain on the surface of the wafer W as in the case of carrying out IPA drying.

Next, the wafer W is transferred into the substrate processing apparatus 10 for post-processing. The wafer W having the watermarks 307 formed thereon as described above is housed in a freely chosen FOUP 14 on a freely chosen FOUP mounting stage 15 of the substrate processing apparatus 10, oriented such that the surface in which the contact holes 303 have been formed is the upper surface. With the wafer W thus housed in the FOUP 14, the substrate processing apparatus 10 is operated so as to carry out COR cleaning processing is carried out.

In the COR cleaning processing, the wafer W is first housed in the chamber 38 of the second processing unit 34 via the transfer arm mechanism 19, the second load lock unit 49, and the third processing unit 36 of the substrate processing apparatus 10. Next, the pressure in the chamber 38 is adjusted to a predetermined pressure, ammonia gas, hydrogen fluoride gas, and argon (Ar) gas as a diluent gas are introduced into the chamber 38 to produce an atmosphere of a mixed gas comprised of ammonia gas, hydrogen fluoride gas and argon gas in the chamber 38, and the watermarks 307 are exposed to the atmosphere of the mixed gas under the predetermined pressure (deposit exposure step) (see FIG. 6G). As a result, a product having a complex structure is produced from the $SiO_2$ constituting each watermark 307, the ammonia gas and the hydrogen fluoride gas, whereby each watermark 307 is altered into a product layer 308 made of the product having the complex structure (see FIG. 6H).

Next, the wafer W on which the product layer 308 has been formed is mounted on the stage heater 51 in the chamber 50 of the third processing unit 36, the pressure in the chamber 50 is adjusted to a predetermined pressure, nitrogen gas is introduced into the chamber 50 to produce viscous flow, and the wafer W is heated to a predetermined temperature using the stage heater 51 (deposit heating step). At this time, the complex structure of the product in the product layer 308 is thermally decomposed, the product being separated into silicon tetrafluoride ($SiF_4$), ammonia, and hydrogen fluoride, which are vaporized. The vaporized molecules are entrained in the viscous flow, and thus discharged from the chamber 50 by the third processing unit exhaust system 67. As a result, the watermarks 307 that were formed on the surface of the wafer W through the spin drying are removed (see FIG. 6I), whereupon the COR cleaning processing comes to an end. The wafer W that has been subjected to the COR cleaning processing is then housed in a predetermined FOUP 14 via the second load lock unit 49 and the transfer arm mechanism 19.

In the second processing unit 34, because hydrogen fluoride gas readily reacts with moisture, it is preferable to set the volume of the ammonia gas to be greater than the volume of the hydrogen fluoride gas in the chamber 38, and moreover it is preferable to remove water molecules from the chamber 38 as much as possible. Specifically, the volumetric flow rate (SCCM) ratio of the hydrogen fluoride gas to the ammonia gas in the mixed gas in the chamber 38 is preferably in a range of 1 to 1/2, and moreover the predetermined pressure in the chamber 38 is preferably in a range of $6.7 \times 10^{-2}$ to 4.0 Pa (0.5 to 30 mTorr). As a result, the flow rate ratio for the mixed gas in the chamber 38 and so on is stabilized, and hence production of the product can be promoted.

Moreover, if the predetermined pressure in the chamber 38 is in a range of $6.7 \times 10^{-2}$ to 4.0 Pa (0.5 to 30 mTorr), then the amount produced of the product can be made to level off reliably after a certain time has elapsed, whereby the etching depth can be reliably controlled (i.e. is self-limited). For example, in the case that the predetermined pressure in the chamber 38 is 1.3 Pa (10 mTorr), the etching stops proceeding after approximately 3 minutes has elapsed from commencement of the COR processing, and the etching depth at this time is approximately 15 nm. Moreover, in the case that the predetermined pressure in the chamber 38 is 2.7 Pa (20 mTorr), the etching stops proceeding after approximately 3 minutes has elapsed from commencement of the COR processing, and the etching depth at this time is approximately 24 nm.

Moreover, the reaction to produce the product is promoted at around room temperature, and hence the temperature of the ESC 39 on which the wafer W is mounted is preferably set to 25°C using the temperature adjusting mechanism (not shown) built therein. Furthermore, the higher the temperature, the less prone by-products formed in the chamber 38 are to become attached to the inner wall of the chamber 38, and hence the temperature of the inner wall of the chamber 38 is preferably set to 50°C using the heater (not shown) embedded in the side wall of the chamber 38.

The product of the reaction is a complex compound containing coordinate bonds. Such a complex compound is weakly bonded together, and hence undergoes thermal decomposition even at a relatively low temperature. In the third processing unit 36, the predetermined temperature of the wafer W is thus preferably in a range of 80 to 200°C, more preferably 100 to 200°C. This is because the temperature of the wafer W when the pressure has been reduced down to the predetermined pressure is preferably in a range of 80 to 200°C, which is a temperature range in which $(NH_4)_2SiF_6$ sublimes, more preferably 125 to 150°C. Furthermore, the time for which the wafer W is subjected to the PHT processing is preferably in a range of 60 to 180 seconds. Moreover, to produce viscous flow in the chamber 50, it is undesirable to make the degree of vacuum in the chamber 50 high, and moreover a gas flow of a certain flow rate is required. The predetermined pressure in the chamber 50 is thus preferably in a range of $6.7 \times 10$ to $1.3 \times 10^2$ Pa (500 mTorr to 1 Torr), and the nitrogen gas flow rate is preferably in a range of 500 to 3000 SCCM. As a result, viscous flow can be produced reliably in the chamber 50, and hence gas molecules produced through the thermal decomposition of the product can be reliably removed.

Moreover, before subjecting each wafer W to the COR processing, it is preferable to measure the shape, for example the film thickness, of the watermarks 307, and in accordance with the measured shape, for the CPU of the EC 89 to decide the values of processing condition parameters in the COR processing and PHT processing based on a predetermined relationship between the shape (film thickness etc.) of the watermarks 307 and processing condition parameters relating to the amount removed of the watermarks 307. As a result, the amount removed of the watermarks 307 can be controlled precisely, and hence the watermarks 307 formed on the surface of the wafer W can be reliably removed, and moreover the efficiency of the COR cleaning processing can be improved.

The above predetermined relationship is set based on the difference in the shape (film thickness etc.) of the watermarks 307 between before and after carrying out the COR processing and PHT processing as measured by the first IMS 17 at the start of a lot in which a plurality of wafers W are to be processed, i.e. the amount removed of the watermarks 307 by the COR processing and PHT processing, and the processing condition parameters in the COR processing and PHT processing at this time. Examples of the processing condition parameters include the volumetric flow rate ratio of the hydrogen fluoride gas to the ammonia gas, the predetermined pressure in the chamber 38, and the heating temperature of the wafer W mounted on the stage heater 51. The predetermined relationship thus set is stored in the HDD of the EC 89 or the like, and is referred to as described above when processing subsequent wafers W in the lot.

Moreover, whether or not to re-perform the COR processing and PHT processing on a given wafer W may be decided based on the difference in the shape (film thickness etc.) of the watermarks 307 between before and after performing the COR processing and PHT processing on that wafer W, and furthermore in the case that it is decided to re-perform the COR processing and PHT processing, the CPU of the EC 89 may decide the processing condition parameters for the COR processing and PHT processing based on the above predetermined relationship in accordance with the shape (film thickness etc.) of the watermarks 307 after carrying out the COR processing and PHT processing on the wafer W in question the first time.

As described above, according to the method of surface processing a substrate of the present example, in cleaning processing, a wafer W that has had watermarks 307 formed on a surface thereof through spin drying is subjected to COR cleaning processing comprised of COR processing in which the wafer W is exposed to an atmosphere of a mixed gas of ammonia gas, hydrogen fluoride gas and argon gas under a predetermined pressure and PHT processing in which the wafer W that has been exposed to the atmosphere of the mixed gas is heated to a predetermined temperature. As a result, a product (product layer 308) having a complex structure is produced from the $SiO_2$ constituting the watermarks 307, the ammonia gas and the hydrogen fluoride gas, and then the complex structure of the produced product is thermally decomposed, the product being separated into silicon tetrafluoride, ammonia and hydrogen fluoride, which are vaporized. Through the product being vaporized, the watermarks 307 can be removed from the surface of the wafer W. Moreover, the COR cleaning processing is carried out under a dry environment, and hence water is not used in the reaction in the COR processing, and moreover even though water molecules are produced through the COR processing, these water molecules are produced in a gaseous state, and hence there is no attachment of water molecules in a liquid state to the wafer W, and thus there is no re-formation of watermarks on the surface of the wafer W from which the watermarks 307 have been removed. Furthermore, the PHT processing is carried out at a high temperature, and hence again there is no re-formation of watermarks on the surface of the wafer W from which the watermarks 307 have been removed. The watermarks and so on can thus be removed, and hence a clean wafer W can be obtained.

Moreover, according to the method of surface processing a substrate of the present example, cleaning is carried out in the order SPM cleaning or plasma ashing, SC1 cleaning, pure water cleaning, SC2 cleaning, pure water cleaning, DHF cleaning, pure water cleaning, spin drying, and the COR cleaning. As a result, particles or ashing residue produced through the SPM cleaning or plasma ashing can be removed through the SC1 cleaning, metal contamination produced through the SPM cleaning or plasma ashing and the SC1 cleaning can be removed through the SC2 cleaning, and native oxide produced through the SC1 cleaning and the SC2 cleaning can be removed through the DHF cleaning, the SMP cleaning and the plasma ashing. Watermarks are produced through the spin drying, but these watermarks can be removed through the COR cleaning. As a result of the above, the watermarks, the contamination, the native oxide and so on can all be reliably removed, and hence a clean wafer W can be obtained.

Moreover, according to the method of surface processing a substrate of the present example, the watermarks 307 are removed by subjecting the wafer W to plasma-less etching. As a result, charge is not accumulated on a gate electrode in an electronic device manufactured from the wafer W, and hence degradation or destruction of a gate oxide film can be prevented. Moreover, the electronic device is not irradiated with energetic particles, and hence semiconductor crystal defects can be prevented from occurring. Furthermore, unanticipated chemical reactions caused by plasma do not occur, and hence generation of impurities can be prevented, whereby contamination of the chamber 38 and the chamber 50 can be prevented.

Furthermore, according to the method of surface processing a substrate of the present example, the watermarks are removed by subjecting the wafer W to dry cleaning. As a result, changes in properties of the surface of the wafer W can be suppressed, and hence a decrease in wiring reliability in an electronic device manufactured from the wafer W can be reliably prevented.

Moreover, according to the method of surface processing a substrate of the present example, IPA drying is not carried out. As a result, production of carbon-based organic matter can be prevented.

Moreover, according to the method of surface processing a substrate of the present example, because watermarks, contamination, native oxide and so on can be reliably removed, a decrease in electronic device reliability can be suppressed.

Moreover, in the COR cleaning processing, the amount produced of the product having the complex structure from the watermarks 307 through the COR processing can be controlled through parameters of the mixed gas of ammonia gas, hydrogen fluoride gas, and argon gas. As a result, the amount removed of the watermarks can be controlled easily by controlling the parameters of the mixed gas. The watermarks formed on the surface of the wafer W can thus reliably removed, and moreover the efficiency of the COR cleaning processing can be improved.

Moreover, the amount produced of the product levels off after a certain time has elapsed, the amount produced of the product being determined by the parameters of the mixed gas. The amount removed of the watermarks 307 can thus be controlled easily, and moreover a decrease in reliability of an electronic device manufactured from the cleaned wafer W can be prevented.

In the method of surface processing a substrate according to the present example, steps are carried out in the order SPM cleaning or plasma ashing, SC1 cleaning, pure water cleaning, SC2 cleaning, pure water cleaning, DHF cleaning, pure water cleaning, spin drying, and COR cleaning. However, the steps in the method of surface processing a substrate (cleaning a substrate) are not limited to this.

For example, in a variation of the method of surface processing a substrate according to the present example, the SC2 cleaning step is omitted, steps being carried out in the order SPM cleaning or plasma ashing, SC1 cleaning, pure water cleaning, DHF cleaning, pure water cleaning, spin drying, and COR cleaning.

Moreover, in another variation of the method of surface processing a substrate according to the present example, the DHF cleaning step is omitted, steps being carried out in the order SPM cleaning or plasma ashing, SC1 cleaning, pure water cleaning, SC2 cleaning, pure water cleaning, spin drying, and COR cleaning.

Moreover, in another variation of the method of surface processing a substrate according to the present example, the order of carrying out the SC2 cleaning step and the DHF cleaning step is changed, steps being carried out in the order SPM cleaning or plasma ashing, SC1 cleaning, pure water cleaning, DHF cleaning, pure water cleaning, SC2 cleaning, pure water cleaning, spin drying, and COR cleaning.

Furthermore, in another variation of the method of surface processing a substrate according to the present example, instead of the DHF cleaning, BHF (buffered hydrofluoric acid) cleaning is carried out using a mixed liquid prepared by dissolving $NH_4F$ (ammonium fluoride) and HF (hydrogen fluoride) in water as a cleaning liquid.

Moreover, in other variations of the method of surface processing a substrate according to the present example, steps are carried out in the order SC1 cleaning, pure water cleaning, spin drying, and COR cleaning, or steps are carried out in the order SC2 cleaning, pure water cleaning, spin drying, and COR cleaning, or steps are carried out in the order DHF cleaning, pure water cleaning, spin drying, and COR cleaning. Even in the case that it is unknown what cleaning liquid has been used in the cleaning processing carried out on a wafer W, a user can thus apply the present surface processing method to the wafer W so as to obtain a clean wafer W. For example, by carrying out SC1 cleaning on a wafer W having particles attached thereto, SC2 cleaning on a wafer W having metal contamination attached thereto, or DHF cleaning on a wafer W having native oxide formed thereon, the particles, contamination or native oxide can be removed, and moreover watermarks produced can be removed.

According to the above variations, cleaning steps are carried out that are optimum for the wafer W being cleaned. As a result, the processing time can be shortened.

Moreover, the substrate cleaned using the method of surface processing a substrate according to the present example is not limited to being a wafer W as described above in which contact holes 303 for source/drain contact have been fabricated in an insulating film 301 formed on the surface of the wafer W so as to reveal the surface of the wafer W in the contact holes 303, but rather may be any wafer W having a revealed surface. Moreover, the substrate cleaned using the method of cleaning a substrate according to the present example is not limited to being such a wafer W having a revealed surface, but rather may be a wafer W in which a surface of a metallic film formed on the wafer W is revealed. In this case, watermarks formed on the revealed metal surface can be removed.

Moreover, the target of the COR cleaning in the method of surface processing a substrate according to the present example is not limited to being watermarks as described above, but rather may be any silicon oxide $(SiO_2)$ that can be removed by the COR processing and PHT processing. For example, the method can be applied to pre-metal-silicon contact formation cleaning, "pre-epi" cleaning, and "pre-silicide" cleaning.

In pre-metal-silicon contact formation cleaning, the COR cleaning is carried out on a wafer before wiring metal is deposited onto the wafer. As a result, a silicon oxide $(SiO_2)$ film formed on the silicon can be removed, and hence the contact resistance in an electronic device manufactured from the wafer can be reduced.

In "pre-epi" cleaning, the COR cleaning is carried out on a wafer before a silicon epitaxial process. As a result, a silicon oxide $(SiO_2)$ film formed on the wafer can be removed, and hence the surface of the wafer can be made clean before the silicon epitaxial process.

In "pre-silicide" cleaning, the COR cleaning is carried out on a polysilicon wafer before depositing silicide metal by CVD. As a result, a silicon oxide $(SiO_2)$ film formed on the polysilicon wafer can be removed, whereby Si diffusion of the silicide metal over the polysilicon wafer is facilitated.

Moreover, in the embodiment described above, the substrate processing apparatus 10 is made to have the orienter 16, the first IMS 17, and the second IMS 18. However, the substrate processing apparatus 10 may have none, or only one or two, of the orienter 16, the first IMS 17, and the second IMS 18.

Furthermore, the present invention is not limited to the example described above. For example, other examples include a method of manufacturing an electronic device, or a method of cleaning an electronic device, including the method of surface processing a substrate described above.

In the example described above, the substrate processing apparatus 10 has one second process ship 12. However, the substrate processing apparatus may have a plurality of second process ships 12 arranged in parallel with one another.

Variations of the substrate processing apparatus to which is applied the method of surface processing a substrate according to the above example will now be described. In the following description, component elements the same as ones of the substrate processing apparatus 10 described above are designated by the same reference numerals as for the substrate processing apparatus 10, and description thereof is omitted here; only different parts are described.

FIG. 8 is a view schematically showing the construction of a substrate cleaning system, which is a first variation of the substrate processing apparatus 1 to which is applied the method of surface processing a substrate according to the above example.

As shown in FIG. 8, the substrate cleaning system 400 of the first variation has a pre-cleaning apparatus 410 that functions as does the pre-cleaning apparatus (not shown) for carrying out the pre-processing in the cleaning process in the method of cleaning a substrate according to the example described above, the substrate processing apparatus 10 shown in FIG. 1, and a buffer apparatus 420 that connects the pre-cleaning apparatus 410 and the substrate processing apparatus 10 together.

The pre-cleaning apparatus 410 is constructed so as to be able to carry out SPM cleaning or plasma ashing, SC1 cleaning, pure water cleaning, SC2 cleaning, pure water cleaning, DHF cleaning, pure water cleaning, and spin drying in this order. Moreover, the pre-cleaning apparatus 410 is constructed such that batch processing can be carried out on a plurality of wafers W in each of the steps.

The buffer apparatus 420 has a transfer arm, not shown, and a buffer chamber, not shown, in which a predetermined number of the wafers W can be stored after having been subjected to the spin drying. The transfer arm is constructed so as to be able to transfer a wafer W that has been subjected to the spin drying in the pre-cleaning apparatus 410 into the buffer chamber so as to house the wafer W in the buffer chamber, and so as to be able to transfer a wafer W housed in the buffer chamber into the substrate processing apparatus 10 and house the wafer W in a predetermined FOUP 14.

Moreover, the system controller of the substrate processing apparatus 10 (see FIG. 5) has an MC, a GHOST network, a DIST board, and an I/O module for each of the pre-cleaning apparatus 410 and the buffer apparatus 420, and thus controls the pre-cleaning apparatus 410 and the buffer apparatus 420.

The system controller administers a processing recipe log for the wafers W to be transferred into the substrate processing apparatus 10 from the pre-cleaning apparatus 410 via the buffer apparatus 420, and also controls the transfer arm so as to control the timing of transfer of each of the wafers W into the substrate processing apparatus 10 from the pre-cleaning apparatus 410.

According to the above construction, in the substrate cleaning system 400, wafers W that have been subjected to batch processing in the pre-cleaning apparatus 410 can be smoothly transferred via the buffer apparatus 420 into the substrate processing apparatus 10 in which processing is carried out on the wafers W one at a time.

As described above, according to the substrate cleaning system of the present variation, wafers W that have been subjected to batch processing in the pre-cleaning apparatus 410 can be smoothly transferred via the buffer apparatus 420 into the substrate processing apparatus 10 in which processing is carried out on the wafers W one at a time. As a result, the substrate cleaning can be carried out efficiently.

The substrate processing apparatus to which is applied the method of surface processing a substrate according to the above example is not limited to being a substrate processing apparatus of a parallel type having two process ships arranged in parallel with one another as shown in FIG. 1, but rather as shown in FIGS. 9 and 10, the substrate processing apparatus may instead be one having a plurality of processing units arranged in a radial manner as vacuum processing chambers in which predetermined processing is carried out on the wafers W.

FIG. 9 is a plan view schematically showing the construction of a second variation of the substrate processing apparatus to which is applied the method of surface processing a substrate according to the above example. In FIG. 9, component elements the same as ones of the substrate processing apparatus 10 shown in FIG. 1 are designated by the same reference numerals as in FIG. 1, and description thereof is omitted here.

As shown in FIG. 9, the substrate processing apparatus 137 is comprised of a transfer unit 138 having a hexagonal shape in plan view, four processing units 139 to 142 arranged in a radial manner around the transfer unit 138, a loader unit 13, and two load lock units 143 and 144 that are each disposed between the transfer unit 138 and the loader unit 13 so as to link the transfer unit 138 and the loader unit 13 together.

The internal pressure of the transfer unit 138 and each of the processing units 139 to 142 is held at vacuum. The transfer unit 138 is connected to the processing units 139 to 142 by vacuum gate valves 145 to 148 respectively.

In the substrate processing apparatus 137, the internal pressure of the loader unit 13 is held at atmospheric pressure, whereas the internal pressure of the transfer unit 138 is held at vacuum. The load lock units 143 and 144 are thus provided respectively with a vacuum gate valve 149 or 150 in a connecting part between that load lock unit and the transfer unit 138, and an atmospheric door valve 151 or 152 in a connecting part between that load lock unit and the loader unit 13, whereby the load lock units 143 and 144 are each constructed as a preliminary vacuum transfer chamber whose internal pressure can be adjusted. Moreover, the load lock units 143 and 144 have respectively therein a wafer mounting stage 153 or 154 for temporarily mounting a wafer W being transferred between the loader unit 13 and the transfer unit 138.

The transfer unit 138 has disposed therein a frog leg-type transfer arm 155 that can bend/elongate and turn. The transfer arm 155 transfers the wafers W between the processing units 139 to 142 and the load lock units 143 and 144.

The processing units 139 to 142 have respectively therein mounting stages 156 to 159 on each of which is mounted a wafer W to be processed. Here, the processing unit 140 is constructed like the first processing unit 25 in the substrate processing apparatus 10, the processing unit 141 is constructed like the second processing unit 34 in the substrate processing apparatus 10, and the processing unit 142 is constructed like the third processing unit 36 in the substrate processing apparatus 10. Each of the wafers W can thus be subjected to the RIE processing in the processing unit 140, the COR processing in the processing unit 141, and the PHT processing in the processing unit 142.

In the substrate processing apparatus 137, the method of surface processing a substrate according to the above example is implemented by transferring a wafer W having watermarks formed thereon into the processing unit 141 and carrying out the COR processing, and then transferring the wafer W into the processing unit 142 and carrying out the PHT processing.

Operation of the component elements in the substrate processing apparatus 137 is controlled using a system controller constructed like the system controller in the substrate processing apparatus 10.

FIG. 10 is a plan view schematically showing the construction of a third variation of the substrate processing apparatus to which is applied the method of surface processing a substrate according to the above example. In FIG. 10, component elements the same as ones of the substrate processing apparatus 10 shown in FIG. 1 or the substrate processing apparatus 137 shown in FIG. 9 are designated by the same reference numerals as in FIG. 1 or FIG. 9, and description thereof is omitted here.

As shown in FIG. 10, compared with the substrate processing apparatus 137 shown in FIG. 9, the substrate processing apparatus 160 has an additional two processing units 161 and 162, and the shape of a transfer unit 163 of the substrate processing apparatus 160 is accordingly different to the shape of the transfer unit 138 of the substrate processing apparatus 137. The additional two processing units 161 and 162 are respectively connected to the transfer unit 163 via a vacuum gate valve 164 or 165, and respectively have therein a wafer W mounting stage 166 or 167.

Moreover, the transfer unit 163 has therein a transfer arm unit 168 comprised of two SCARA-type transfer arms. The transfer arm unit 168 moves along guide rails 169 provided in the transfer unit 163, and transfers the wafers W between the processing units 139 to 142, 161 and 162, and the load lock units 143 and 144.

In the substrate processing apparatus 160, as for the substrate processing apparatus 137, the method of surface processing a substrate according to the above example is implemented by transferring a wafer W having watermarks formed thereon into the processing unit 141 and carrying out the COR processing, and then transferring the wafer W into the processing unit 142 and carrying out the PHT processing.

Operation of the component elements in the substrate processing apparatus 160 is again controlled using a system controller constructed like the system controller in the substrate processing apparatus 10.

Examples of the above electronic device include semiconductor devices, and also non-volatile or high-capacity memory devices having therein a thin film made of an insulating metal oxide material such as a ferroelectric material or a high dielectric material, in particular a material having a perovskite crystal structure. Examples of materials having a perovskite crystal structure include lead zirconate titanate (PZT), barium strontium titanate (BST), and strontium bismuth niobium tantalate (SBNT).

It is to be understood that the object of the present invention as claimed in claim 1 can also be attained by supplying to a system or apparatus (the EC 89) a storage medium in which a program code is stored, and then causing a computer (or CPU, MPU, or the like) of the system or apparatus (EC 89) to read out and execute the program code stored in the storage medium.

In this case, the program code itself read out from the storage medium realizes the functions described above.

The storage medium for supplying the program code may be, for example, a floppy (registered trademark) disk, a hard disk, a magnetic-optical disk, a CD-ROM, a CD-R, a CD-RW, a DVD-ROM, a DVD-RAM, a DVD-RW, a DVD+RW, a magnetic tape, a non-volatile memory card, and a ROM. Alternatively, the program code may be downloaded via a network.

Moreover, it is to be understood that the functions described may be accomplished not only by executing a program code read out by a computer, but also by causing an OS (operating system) or the like which operates on the computer to perform a part or all of the actual operations based on instructions of the program code.

Furthermore, it is to be understood that the functions described may be accomplished by writing a program code read out from the storage medium into a memory provided on an expansion board inserted into a computer or in an expansion unit connected to the computer or in an expansion unit connected to the computer and then causing a CPU or the like provided on the expansion board or in the expansion unit to perform a part or all of the actual operations based on instructions of the program code.

The form of the program code may be, for example, object code, program code executed by an interpreter, or script data supplied to an OS.

## Claims

1.  A method of surface processing a substrate in which deposit is removed from the substrate, the method comprising:

    a liquid chemical cleaning step of cleaning the substrate with a liquid chemical;
    a deposit exposure step of exposing the deposit to an atmosphere of a mixed gas containing ammonia and hydrogen fluoride under a predetermined pressure; and
    a deposit heating step of heating to a predetermined temperature the deposit that has been exposed to the atmosphere of the mixed gas.

2.  A method as claimed in claim 1, wherein in said deposit exposure step, the substrate is subjected to plasma-less etching.

3.  A method as claimed in claim 1, wherein in said deposit exposure step, the substrate is subjected to dry cleaning.

4.  A method as claimed in claim 1, wherein the predetermined pressure in said deposit exposure step is in a range of $6.7 \times 10^{-2}$ to 4.0 Pa, and the predetermined temperature in said deposit heating step is in a range of 100 to 200°C.

5.  A method as claimed in claim 1, wherein the deposit is silicon oxide formed on the substrate.

6.  A method as claimed in claim 1, further comprising a product production condition deciding step of measuring a shape of the deposit, and deciding at least one of a volumetric flow rate ratio of the hydrogen fluoride to the ammonia in the mixed gas and the predetermined pressure in accordance with the measured shape.

7.  A method as claimed in claim 1, further comprising a rinsing liquid cleaning step of cleaning the substrate with a rinsing liquid after said liquid chemical cleaning step.

8.  A method as claimed in claim 7, further comprising a spin drying step of spin drying the substrate after said rinsing liquid cleaning step.

9.  A method as claimed in claim 1, wherein the substrate has a first layer formed on the substrate, a photoresist layer having a predetermined pattern formed on the first layer, and at least one connecting hole fabricated in the first layer by etching using the photoresist layer, wherein the method further comprises a photoresist removal step of removing the photoresist layer, and wherein in the liquid chemical cleaning step, the substrate is cleaned with the liquid chemical that forms a hydrophilic layer on a surface of the substrate.

10. A method as claimed in claim 9, wherein the liquid chemical is one of SC1 and SC2.

11. A method as claimed in claim 9, wherein the hydrophilic layer is a silicon native oxide film.

12. A method as claimed in claim 1, wherein the substrate has a first layer formed on the substrate, a photoresist layer having a predetermined pattern formed on the first layer, and at least one connecting hole fabricated in the first layer by etching using the photoresist layer, wherein the method further comprises a photoresist removal step of removing the photoresist layer, and wherein in the liquid chemical cleaning step, the substrate is cleaned with the liquid chemical that forms a hydrophobic surface on a surface of the substrate.

13. A method as claimed in claim 12, wherein the liquid chemical is a hydrogen fluoride aqueous solution.

14. A method as claimed in claim 1, wherein the substrate has a first layer formed on the substrate, a photoresist layer having a predetermined pattern formed on the first layer, and at least one connecting hole fabricated in the first layer by etching using the photoresist layer, wherein the method further comprises a photoresist removal step of removing the photoresist layer, wherein the liquid chemical cleaning step has a first wet cleaning step of cleaning the substrate with SC1;
    a second wet cleaning step of cleaning with SC2 the substrate that has been cleaned in the first wet cleaning step; and
    a third wet cleaning step of cleaning with a hydrogen fluoride aqueous solution the substrate that has been cleaned in the second wet cleaning step, wherein the method furthermore comprises a drying step of drying the substrate that has been cleaned in the third wet cleaning step, and wherein in the deposit exposure step, the substrate that has been dried in the drying step is exposed to the atmosphere of the mixed gas containing ammonia and hydrogen fluoride under the predetermined pressure.

15. A method as claimed in claim 1, wherein the substrate has a first layer formed on the substrate, a photoresist layer having a predetermined pattern formed on the first layer, and at least one connecting hole fabricated in the first layer by etching using the photoresist layer, wherein the method further comprises a photoresist removal step of removing the photoresist layer, wherein the liquid chemical cleaning step has a first wet cleaning step of cleaning the substrate with SC1; and

a second wet cleaning step of cleaning with a hydrogen fluoride aqueous solution the substrate that has been cleaned in the first wet cleaning step, wherein the method further comprises a drying step of drying the substrate that has been cleaned in the second wet cleaning step, and wherein in the deposit exposure step, the substrate that has been dried in the drying step is exposed to the atmosphere of the mixed gas containing ammonia and hydrogen fluoride under the predetermined pressure.

16. A method as claimed in claim 1, wherein the substrate has a first layer formed on the substrate, a photoresist layer having a predetermined pattern formed on the first layer, and at least one connecting hole fabricated in the first layer by etching using the photoresist layer, wherein the method further comprises a photoresist removal step of removing the photoresist layer, wherein the liquid chemical cleaning step has a first wet cleaning step of cleaning the substrate with SC1; and

a second wet cleaning step of cleaning with SC2 the substrate that has been cleaned in the first wet cleaning step, wherein the method furthermore comprises a drying step of drying the substrate that has been cleaned in the second wet cleaning step, and wherein in the deposit exposure step, the substrate that has been dried in the drying step is exposed to the atmosphere of the mixed gas containing ammonia and hydrogen fluoride under the predetermined pressure.

17. A method as claimed in claim 1, wherein the substrate has a first layer formed on the substrate, a photoresist layer having a predetermined pattern formed on the first layer, and at least one connecting hole fabricated in the first layer by etching using the photoresist layer, wherein the method further comprises a photoresist removal step of removing the photoresist layer, wherein the liquid chemical cleaning step has a first wet cleaning step of cleaning the substrate with SC1;

a second wet cleaning step of cleaning with a hydrogen fluoride aqueous solution the substrate that has been cleaned in the first wet cleaning step; and

a third wet cleaning step of cleaning with SC2 the substrate that has been cleaned in the second wet cleaning step, wherein the method furthermore comprises a drying step of drying the substrate that has been cleaned in the third wet cleaning step, and wherein in the deposit exposure step, the substrate that has been dried in the drying step is exposed to the atmosphere of the mixed gas containing ammonia and hydrogen fluoride under the predetermined pressure.

18. A program for causing a computer to execute a method of surface processing a substrate in which deposit is removed from the substrate, the program comprising:

a liquid chemical cleaning module for cleaning the substrate with a liquid chemical;
a deposit exposure module for exposing the deposit to an atmosphere of a mixed gas containing ammonia and hydrogen fluoride under a predetermined pressure; and
a deposit heating module for heating to a predetermined temperature the deposit that has been exposed to the atmosphere of the mixed gas.

19. A program as claimed in claim 18, wherein the substrate has a first layer formed on the substrate, a photoresist layer having a predetermined pattern formed on the first layer, and at least one connecting hole fabricated in the first layer by etching using the photoresist layer, wherein the program further comprises a photoresist removal module for removing the photoresist layer, and wherein the liquid chemical cleaning module cleans the substrate with a liquid chemical that forms a hydrophilic layer on a surface of the substrate.

20. A program as claimed in claim 18, wherein the substrate has a first layer formed on the substrate, a photoresist layer having a predetermined pattern formed on the first layer, and at least one connecting hole fabricated in the first layer by etching using the photoresist layer, wherein the program further comprises a photoresist removal module for removing the photoresist layer, and wherein the liquid chemical cleaning module cleans the substrate with a liquid chemical that forms a hydrophobic surface on a surface of the substrate.

21. A program as claimed in claim 18, wherein the substrate has a first layer formed on the substrate, a photoresist layer having a predetermined pattern formed on the first layer, and at least one connecting hole fabricated in the first layer by etching using the photoresist layer, wherein the program further comprises a photoresist removal module for removing the photoresist layer, wherein the liquid chemical cleaning module has a first wet cleaning module for cleaning the substrate with SC1;

a second wet cleaning module for cleaning with SC2 the substrate that has been cleaned in the first wet cleaning module; and

a third wet cleaning module for cleaning with a hydrogen fluoride aqueous solution the substrate that has been cleaned in the second wet cleaning module, wherein the program furthermore comprises a drying module for drying the substrate that has been cleaned in the third wet cleaning module, and wherein the deposit exposure module exposes the substrate that has been dried in the drying module to the atmosphere of the mixed gas containing ammonia and hydrogen fluoride under the predetermined pressure.

22. A program as claimed in claim 18, wherein the substrate has a first layer formed on the substrate, a photoresist layer having a predetermined pattern formed on the first layer, and at least one connecting hole fabricated in the first layer by etching using the photoresist layer, wherein the program further comprises a photoresist removal module for removing the photoresist layer, wherein the liquid chemical cleaning module has a first wet cleaning module for cleaning the substrate with SC1; and

a second wet cleaning module for cleaning with a hydrogen fluoride aqueous solution the substrate that has been cleaned in the first wet cleaning module, wherein the program furthermore comprises a drying module for drying the substrate that has been cleaned in the second wet cleaning module, and wherein the deposit exposure module exposes the substrate that has been dried in the drying module to the atmosphere of the mixed gas containing ammonia and hydrogen fluoride under the predetermined pressure.

23. A program as claimed in claim 18 wherein the substrate has a first layer formed on the substrate, a photoresist layer having a predetermined pattern formed on the first layer, and at least one connecting hole fabricated in the first layer by etching using the photoresist layer, wherein the program further comprises a photoresist removal module for removing the photoresist layer, wherein the liquid chemical cleaning module has a first wet cleaning module for cleaning the substrate with SC1; and

a second wet cleaning module for cleaning with SC2 the substrate that has been cleaned in the first wet cleaning module, wherein the program furthermore comprises a drying module for drying the substrate that has been cleaned in the second wet cleaning module, and wherein the deposit exposure module exposes the substrate that has been dried in the drying module to the atmosphere of the mixed gas containing ammonia and hydrogen fluoride under the predetermined pressure.

24. A program as claimed in claim 18, wherein the substrate has a first layer formed on the substrate, a photoresist layer having a predetermined pattern formed on the first layer, and at least one connecting hole fabricated in the first layer by etching using the photoresist layer, wherein the program further comprises a photoresist removal module for removing the photoresist layer, wherein the liquid chemical cleaning module has a first wet cleaning module for cleaning the substrate with SC1;

a second wet cleaning module for cleaning with a hydrogen fluoride aqueous solution the substrate that has been cleaned in the first wet cleaning module; and

a third wet cleaning module for cleaning with SC2 the substrate that has been cleaned in the second wet cleaning module, wherein the program furthermore comprises a drying module for drying the substrate that has been cleaned in the third wet cleaning module, and wherein the deposit exposure module exposes the substrate that has been dried in the drying module to the atmosphere of the mixed gas containing ammonia and hydrogen fluoride under the predetermined pressure.

**Patentansprüche**

1. Verfahren zur Oberflächenbearbeitung eines Substrats, bei dem eine Ablagerung vom Substrat entfernt wird, wobei das Verfahren folgende Schritte umfasst:

einen Schritt der Reinigung mit einer flüssigen Chemikalie, bei dem das Substrat mit einer flüssigen Chemikalie gereinigt wird;
einen Schritt der Aussetzung der Ablagerung, bei dem die Ablagerung einer Atmosphäre eines Gasgemisches, welches Ammoniak und Fluorwasserstoff enthält, unter einem vorbestimmten Druck ausgesetzt wird; und
einen Schritt der Erwärmung der Ablagerung, bei dem die Ablagerung, die der Atmosphäre des Gasgemisches ausgesetzt wurde, auf eine vorbestimmte Temperatur erwärmt wird.

2. Verfahren gemäß Anspruch 1, wobei das Substrat bei dem Schritt der Aussetzung der Ablagerung plasmalosem Ätzen unterworfen wird.

3. Verfahren gemäß Anspruch 1, wobei das Substrat bei dem Schritt der Aussetzung der Ablagerung Trockenreinigung unterworfen wird.

4. Verfahren gemäß Anspruch 1, wobei der vorbestimmte Druck bei dem Schritt der Aussetzung der Ablagerung im Bereich von $6{,}7 \times 10^{-2}$ bis $4{,}0$ Pa ist und die vorbestimmte Temperatur bei dem Schritt der Erwärmung der Ablagerung im Bereich von 100 bis 200°C ist.

5. Verfahren gemäß Anspruch 1, wobei die Ablagerung auf dem Substrat gebildetes Siliziumoxid ist.

6. Verfahren gemäß Anspruch 1, weiterhin umfassend einen Schritt der Bestimmung der Produkt-Produktionsbedingung, wobei eine Form der Ablagerung gemessen wird und anhand der gemessenen Form mindestens eines von einem Volumenstromverhältnis zwischen dem Fluorwasserstoff und dem Ammoniak in dem Gasgemisch und dem vorbestimmten Druck bestimmt wird.

7. Verfahren gemäß Anspruch 1, weiterhin umfassend einen Schritt der Reinigung mit Spülflüssigkeit, bei dem das Substrat nach dem Schritt der Reinigung mit einer flüssigen Chemikalie mit einer Spülflüssigkeit gereinigt wird.

8. Verfahren gemäß Anspruch 7, weiterhin umfassend einen Schritt der Schleudertrocknung, bei dem das Substrat nach dem Schritt der Reinigung mit Spülflüssigkeit schleudergetrocknet wird.

9. Verfahren gemäß Anspruch 1, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Verfahren weiterhin einen Schritt der Fotolackentfernung umfasst, bei dem die Fotolackschicht entfernt wird und wobei bei dem Schritt der Reinigung mit einer flüssigen Chemikalie das Substrat mit der flüssigen Chemikalie, die eine hydrophile Schicht auf einer Oberfläche des Substrats bildet, gereinigt wird.

10. Verfahren gemäß Anspruch 9, wobei die flüssige Chemikalie eine von SC1 und SC2 ist.

11. Verfahren gemäß Anspruch 9, wobei die hydrophile Schicht ein nativer Oxidfilm von Silizium ist.

12. Verfahren gemäß Anspruch 1, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Verfahren weiterhin einen Schritt der Fotolackentfernung umfasst, bei dem die Fotolackschicht entfernt wird und wobei bei dem Schritt der Reinigung mit einer flüssigen Chemikalie das Substrat mit der flüssigen Chemikalie, die eine hydrophobe Oberfläche auf einer Oberfläche des Substrats bildet, gereinigt wird.

13. Verfahren gemäß Anspruch 12, wobei die flüssige Chemikalie eine wässrige Fluorwasserstoff-Lösung ist.

14. Verfahren gemäß Anspruch 1, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Verfahren weiterhin einen Schritt der Fotolackentfernung umfasst, bei dem die Fotolackschicht entfernt wird, wobei der Schritt der Reinigung mit einer flüssigen Chemikalie einen ersten Schritt der Feuchtreinigung hat, bei dem das Substrat mit SC1 gereinigt wird; einen zweiten Schritt der Feuchtreinigung, bei dem das Substrat, das bei dem ersten Schritt der Feuchtreinigung gereinigt wurde, mit SC2 gereinigt wird; und einen dritten Schritt der Feuchtreinigung, bei dem das Substrat, das bei dem zweiten Schritt der Feuchtreinigung gereinigt wurde, mit einer wässrigen Fluorwasserstofflösung gereinigt wird, wobei das Verfahren weiterhin einen Schritt der Trocknung umfasst, bei dem das Substrat, das bei dem dritten Schritt der Feuchtreinigung gereinigt wurde, getrocknet wird und wobei das Substrat, das bei dem Schritt der Trocknung getrocknet wurde, bei dem Schritt der Aussetzung der Ablagerung der Atmosphäre des Gasgemisches, welches Ammoniak und Fluorwasserstoff enthält, unter dem vorbestimmten Druck ausgesetzt wird.

15. Verfahren gemäß Anspruch 1, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Verfahren weiterhin einen Schritt der Fotolackentfernung umfasst, bei dem die Fotolackschicht entfernt wird, wobei der Schritt der Reinigung mit einer flüssigen Chemikalie einen ersten Schritt der Feuchtreinigung hat, bei dem das Substrat mit SC1 gereinigt wird; und einen zweiten Schritt der Feuchtreinigung, bei dem das Substrat, das bei dem ersten Schritt der Feuchtreinigung gereinigt wurde, mit einer wässrigen Fluorwasserstofflösung gereinigt wird, wobei das Verfahren weiterhin einen Schritt der Trocknung umfasst, bei dem das Substrat, das bei dem zweiten Schritt der Feuchtreinigung gereinigt wurde, getrocknet wird und wobei das Substrat, das bei dem Schritt der Trocknung getrocknet wurde, bei dem Schritt der Aussetzung der Ablagerung der Atmosphäre des Gasgemisches, welches Ammoniak und Fluorwasserstoff enthält, unter dem vorbestimmten Druck ausgesetzt wird.

16. Verfahren gemäß Anspruch 1, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Verfahren weiterhin einen Schritt der Fotolackentfernung umfasst, bei dem die Fotolackschicht entfernt wird, wobei der Schritt der Reinigung mit einer flüssigen Chemikalie einen ersten Schritt der Feuchtreinigung hat, bei dem das Substrat mit SC1 gereinigt wird; und einen zweiten Schritt der Feuchtreinigung, bei dem das Substrat, das bei dem ersten Schritt der Feuchtreinigung gereinigt wurde, mit SC2 gereinigt wird; wobei das Verfahren weiterhin einen Schritt der Trocknung umfasst, bei dem das Substrat, das bei dem zweiten Schritt der Feuchtreinigung gereinigt wurde, getrocknet wird und wobei das Substrat, das bei dem Schritt der Trocknung getrocknet wurde, bei dem Schritt der Aussetzung der Ablagerung der Atmosphäre des Gasgemisches, welches Ammoniak und Fluorwasserstoff enthält, unter dem vorbestimmten Druck ausgesetzt wird.

17. Verfahren gemäß Anspruch 1, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Verfahren weiterhin einen Schritt der Fotolackentfernung umfasst, bei dem die Fotolackschicht entfernt wird, wobei der Schritt der Reinigung mit einer flüssigen Chemikalie einen ersten Schritt der Feuchtreinigung hat, bei dem das Substrat mit SC1 gereinigt wird; einen zweiten Schritt der Feuchtreinigung, bei dem das Substrat, das bei dem ersten Schritt der Feuchtreinigung gereinigt wurde, mit einer wässrigen Fluorwasserstofflösung gereinigt wird; und einen dritten Schritt der Feuchtreinigung, bei dem das Substrat, das bei dem zweiten Schritt der Feuchtreinigung gereinigt wurde, mit SC2 gereinigt wird, wobei das Verfahren weiterhin einen Schritt der Trocknung umfasst, bei dem das Substrat, das bei dem dritten Schritt der Feuchtreinigung gereinigt wurde, getrocknet wird und wobei das Substrat, das bei dem Schritt der Trocknung getrocknet wurde, bei dem Schritt der Aussetzung der Ablagerung der Atmosphäre des Gasgemisches, welches Ammoniak und Fluorwasserstoff enthält, unter dem vorbestimmten Druck ausgesetzt wird

18. Programm, welches einen Computer dazu bringt ein Verfahren zur Oberflächenbearbeitung eines Substrats, bei dem eine Ablagerung vom Substrat entfernt wird, auszuführen, wobei das Programm folgendes umfasst:

ein Modul der Reinigung mit einer flüssigen Chemikalie zur Reinigung des Substrats mit einer flüssigen Chemikalie;

ein Modul der Aussetzung der Ablagerung zur Aussetzung der Ablagerung einer Atmosphäre eines Gasgemisches, welches Ammoniak und Fluorwasserstoff enthält, unter einem vorbestimmten Druck; und ein Modul der Erwärmung der Ablagerung zum Erwärmen der Ablagerung, die der Atmosphäre des Gasgemisches ausgesetzt wurde, auf eine vorbestimmte Temperatur.

19. Programm gemäß Anspruch 18, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Programm weiterhin ein Modul der Fotolackentfernung umfasst zur Entfernung der Fotolackschicht und wobei das Modul der Reinigung mit einer flüssigen Chemikalie das Substrat mit einer flüssigen Chemikalie, die eine hydrophile Schicht auf einer Oberfläche des Substrats bildet, reinigt.

20. Programm gemäß Anspruch 18, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Programm weiterhin ein Modul der Fotolackentfernung umfasst zur Entfernung der Fotolackschicht und wobei das Modul der Reinigung mit einer flüssigen Chemikalie das Substrat mit einer flüssigen Chemikalie, die eine hydrophobe Oberfläche auf einer Oberfläche des Substrats bildet, reinigt.

21. Programm gemäß Anspruch 18, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Programm weiterhin ein Modul der Fotolackentfernung umfasst zur Entfernung der Fotolackschicht, wobei das Modul der Reinigung mit einer flüssigen Chemikalie ein erstes Modul der Feuchtreinigung zur Reinigung des Substrats mit SC1 hat; ein zweites Modul der Feuchtreinigung zur Reinigung des Substrats, das im ersten Modul der Feuchtreinigung gereinigt wurde, mit SC2; und ein drittes Modul der Feuchtreinigung zur Reinigung des Substrats, das im zweiten Modul der Feuchtreinigung gereinigt wurde, mit einer wässrigen Fluorwasserstofflösung, wobei das Programm weiterhin ein Modul der Trocknung zur Trocknung des Substrats, das im dritten Modul der Feuchtreinigung gereinigt wurde, umfasst und wobei das Modul der Aussetzung der Ablagerung das Substrat, das im Modul der Trocknung getrocknet wurde, der Atmosphäre des Gasgemisches, welches Ammoniak und Fluorwasserstoff enthält, unter dem vorbestimmten Druck aussetzt.

22. Programm gemäß Anspruch 18, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Programm weiterhin ein Modul der Fotolackentfernung umfasst zur Entfernung der Fotolackschicht, wobei das Modul der Reinigung mit einer flüssigen Chemikalie ein erstes Modul der Feuchtreinigung zur Reinigung des Substrats mit SC1 hat; und

ein zweites Modul der Feuchtreinigung zur Reinigung des Substrats, das im ersten Modul der Feuchtreinigung gereinigt wurde, mit einer wässrigen Fluorwasserstofflösung, wobei das Programm weiterhin ein Modul der Trocknung zur Trocknung des Substrats, das im zweiten Modul der Feuchtreinigung gereinigt wurde, umfasst und wobei das Modul der Aussetzung der Ablagerung das Substrat, das im Modul der Trocknung getrocknet wurde, der Atmosphäre des Gasgemisches, welches Ammoniak und Fluorwasserstoff enthält, unter dem vorbestimmten Druck aussetzt.

23. Programm gemäß Anspruch 18, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Programm weiterhin ein Modul der Fotolackentfernung umfasst zur Entfernung der Fotolackschicht, wobei das Modul der Reinigung mit einer flüssigen Chemikalie ein erstes Modul der Feuchtreinigung zur Reinigung des Substrats mit SC1 hat; und

ein zweites Modul der Feuchtreinigung zur Reinigung des Substrats, das im ersten Modul der Feuchtreinigung gereinigt wurde, mit SC2, wobei das Programm weiterhin ein Modul der Trocknung zur Trocknung des Substrats, das im zweiten Modul der Feuchtreinigung gereinigt wurde, umfasst und wobei das Modul der Aussetzung der Ablagerung das Substrat, das im Modul der Trocknung getrocknet wurde, der Atmosphäre des Gasgemisches, welches Ammoniak und Fluorwasserstoff enthält, unter dem vorbestimmten Druck aussetzt.

24. Programm gemäß Anspruch 18, wobei das Substrat eine erste, auf dem Substrat gebildete, Schicht aufweist, eine auf der ersten Schicht gebildete Fotolackschicht mit einem vorbestimmten Muster und mindestens ein Verbindungsloch, welches mithilfe der Fotolackschicht, in die erste Schicht geätzt ist, wobei das Programm weiterhin ein Modul der Fotolackentfernung umfasst zur Entfernung der Fotolackschicht, wobei das Modul der Reinigung mit einer flüssigen Chemikalie ein erstes Modul der Feuchtreinigung zur Reinigung des Substrats mit SC1 hat;

ein zweites Modul der Feuchtreinigung zur Reinigung des Substrats, das im ersten Modul der Feuchtreinigung gereinigt wurde, mit einer wässrigen Fluorwasserstofflösung; und

ein drittes Modul der Feuchtreinigung zur Reinigung des Substrats, das im zweiten Modul der Feuchtreinigung gereinigt wurde, mit SC2, wobei das Programm weiterhin ein Modul der Trocknung zur Trocknung des Substrats, das im dritten Modul der Feuchtreinigung gereinigt wurde, umfasst und wobei das Modul der Aussetzung der Ablagerung das Substrat, das im Modul der Trocknung getrocknet wurde, der Atmosphäre des Gasgemisches, welches Ammoniak und Fluorwasserstoff enthält, unter dem vorbestimmten Druck aussetzt.

**Revendications**

1. Procédé de traitement de surface d'un substrat dans lequel du dépôt est enlevé du substrat, le procédé comprenant :

    une étape de nettoyage par produit chimique liquide consistant à nettoyer le substrat avec un produit chimique liquide ;
    une étape d'exposition de dépôt consistant à exposer le dépôt à une atmosphère d'un gaz mélangé contenant de l'ammoniac et du fluorure d'hydrogène sous une pression prédéterminée ; et
    une étape de chauffage de dépôt consistant à chauffer jusqu'à une température prédéterminée le dépôt qui a été exposé à l'atmosphère du gaz mélangé.

2. Procédé selon la revendication 1, dans lequel, dans ladite étape d'exposition de dépôt, le substrat est soumis à de la gravure sans plasma.

3. Procédé selon la revendication 1, dans lequel, dans ladite étape d'exposition de dépôt, le substrat est soumis à du nettoyage à sec.

4. Procédé selon la revendication 1, dans lequel la pression prédéterminée dans ladite étape d'exposition de dépôt est dans une plage de 6,7 x $10^{-2}$ à 4,0 Pa, et la température prédéterminée dans ladite étape de chauffage de dépôt est dans une plage de 100 à 200 °C.

5. Procédé selon la revendication 1, dans lequel le dépôt est de l'oxyde de silicium formé sur le substrat.

6. Procédé selon la revendication 1, comprenant en outre une étape de décision de condition de production de produit consistant à mesurer une forme du dépôt, et à décider d'au moins un(e) d'un rapport de débit volumétrique du fluorure hydrogène sur l'ammoniac dans le gaz mélangé et de la pression prédéterminée selon la forme mesurée.

7. Procédé selon la revendication 1, comprenant en outre une étape de nettoyage par liquide de rinçage consistant à nettoyer le substrat avec un liquide de rinçage après ladite étape de nettoyage par produit chimique liquide.

8. Procédé selon la revendication 7, comprenant en outre une étape de séchage par tournoiement consistant à sécher le substrat par tournoiement après ladite étape de nettoyage par liquide de rinçage.

9. Procédé selon la revendication 1, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le procédé comprend en outre une étape d'enlèvement de photorésist consistant à enlever la couche de photorésist, et dans lequel, dans l'étape de nettoyage par produit chimique liquide, le substrat est nettoyé avec le produit chimique liquide qui forme une couche hydrophile sur une surface du substrat.

10. Procédé selon la revendication 9, dans lequel le liquide chimique est un de SC1 et SC2.

11. Procédé selon la revendication 9, dans lequel la couche hydrophile est un film d'oxyde de silicium natif.

12. Procédé selon la revendication 1, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le procédé comprend en outre une étape d'enlèvement de photorésist consistant à enlever la couche de photorésist, et dans lequel, dans l'étape de nettoyage par produit chimique liquide, le substrat est nettoyé avec le produit chimique former qui forme une surface hydrophobe sur une surface du substrat.

13. Procédé selon la revendication 12, dans lequel le produit chimique liquide est une solution aqueuse de fluorure d'hydrogène.

14. Procédé selon la revendication 1, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le procédé comprend en outre une étape d'enlèvement de photorésist consistant à enlever la couche de photorésist, dans lequel l'étape de nettoyage par produit chimique liquide a une première étape de nettoyage humide consistant à nettoyer le substrat avec du SC 1 ; une deuxième étape de nettoyage humide consistant à nettoyer avec du SC2 le substrat qui a été nettoyé dans la première étape de nettoyage humide ; et une troisième étape de nettoyage humide consistant à nettoyer avec une solution aqueuse de fluorure d'hydrogène le substrat qui a été nettoyé dans la deuxième étape de nettoyage humide, dans lequel le procédé comprend en outre une étape de séchage consistant à sécher le substrat qui a été nettoyé dans la troisième étape de nettoyage humide, et dans lequel dans l'étape d'exposition de dépôt, le substrat qui a été séché dans l'étape de séchage est exposé à l'atmosphère du gaz mélangé contenant de l'ammoniac et du fluorure d'hydrogène sous la pression prédéterminée.

15. Procédé selon la revendication 1, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le procédé comprend en outre une étape d'enlèvement de photorésist consistant à enlever la couche de photorésist, dans lequel l'étape de nettoyage par produit chimique liquide a une première étape de nettoyage humide consistant à nettoyer le substrat avec du SC1 ; et une deuxième étape de nettoyage humide consistant à nettoyer avec une solution aqueuse de fluorure d'hydrogène le substrat qui a été nettoyé dans la première étape de nettoyage humide, dans lequel le procédé comprend en outre une étape de séchage consistant à sécher le substrat qui a été nettoyé dans la seconde étape de nettoyage humide, et dans lequel dans l'étape d'exposition de dépôt, le substrat qui a été séché dans l'étape de séchage est exposé à l'atmosphère du gaz mélangé contenant de l'ammoniac et du fluorure d'hydrogène sous la pression prédéterminée.

16. Procédé selon la revendication 1, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le procédé comprend en outre une étape d'enlèvement de photorésist consistant à enlever la couche de photorésist, dans lequel l'étape de nettoyage par produit chimique liquide a une première étape de nettoyage humide consistant à nettoyer le substrat avec du SC1 ; et

une deuxième étape de nettoyage humide consistant à nettoyer avec du SC2 le substrat qui a été nettoyé dans la première étape de nettoyage humide, dans lequel le procédé comprend en outre une étape de séchage consistant à sécher le substrat qui a été nettoyé dans la deuxième étape de nettoyage humide, et dans lequel, dans l'étape d'exposition de dépôt, le substrat qui a été séché dans l'étape de séchage est exposé à l'atmosphère du gaz mélangé contenant de l'ammoniac et du fluorure d'hydrogène sous la pression prédéterminée.

17. Procédé selon la revendication 1, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le procédé comprend en outre une étape d'enlèvement de photorésist consistant à enlever la couche de photorésist, dans lequel l'étape de nettoyage par produit chimique liquide a une première étape de nettoyage humide consistant à nettoyer le substrat avec du SC1 ;

une deuxième étape de nettoyage humide consistant à nettoyer avec une solution aqueuse de fluorure d'hydrogène le substrat qui a été nettoyé dans la première étape de nettoyage humide ; et

une troisième étape de nettoyage humide consistant à nettoyer avec du SC2 le substrat qui a été nettoyé dans la deuxième étape de nettoyage humide, dans lequel le procédé comprend en outre une étape de séchage consistant à sécher le substrat qui a été nettoyé dans la troisième étape de nettoyage humide, et dans lequel, dans l'étape d'exposition de dépôt, le substrat qui a été séché dans l'étape de séchage est exposé à l'atmosphère du gaz mélangé contenant de l'ammoniac et du fluorure d'hydrogène sous la pression prédéterminée.

18. Programme pour amener un ordinateur à exécuter un procédé de traitement de surface d'un substrat dans lequel du dépôt est enlevé du substrat, le programme comprenant :

un module de nettoyage par produit chimique liquide pour nettoyer le substrat avec un produit chimique liquide ;

un module d'exposition de dépôt pour exposer le dépôt à une atmosphère d'un gaz mélangé contenant de l'ammoniac et du fluorure d'hydrogène sous une pression prédéterminée ; et

un module de chauffage de dépôt pour chauffer jusqu'à une température prédéterminée le dépôt qui a été exposé à l'atmosphère du gaz mélangé.

19. Programme selon la revendication 18, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le programme comprend en outre un module d'enlèvement de photorésist pour enlever la couche de photorésist, et dans lequel le module de nettoyage par produit chimique liquide nettoie le substrat avec un produit chimique liquide qui forme une couche hydrophile sur une surface du substrat.

20. Programme selon la revendication 18, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le programme comprend en outre un module d'enlèvement de photorésist pour enlever la couche de photorésist, et dans lequel le module de nettoyage par produit chimique liquide nettoie le substrat avec un produit chimique liquide qui forme une surface hydrophobe sur une surface du substrat.

21. Programme selon la revendication 18, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le programme comprend en outre un module d'enlèvement de photorésist pour enlever la couche de photorésist, dans lequel le module de nettoyage par produit chimique liquide a un premier module de nettoyage humide pour nettoyer le substrat avec du SC1 ;

un deuxième module de nettoyage humide pour nettoyer avec du SC2 le substrat qui a été nettoyé dans le premier module de nettoyage humide ; et

un troisième module de nettoyage humide pour nettoyer avec une solution aqueuse de fluorure d'hydrogène le substrat qui a été nettoyé dans le deuxième module de nettoyage humide, dans lequel le programme comprend en outre un module de séchage pour sécher le substrat qui a été nettoyé dans le troisième module de nettoyage humide, et dans lequel le module d'exposition de dépôt expose le substrat qui a été séché dans le module de séchage à l'atmosphère du gaz mélangé contenant de l'ammoniac et du fluorure d'hydrogène sous la pression prédéterminée.

**22.** Programme selon la revendication 18, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le programme comprend en outre un module d'enlèvement de photorésist pour enlever la couche de photorésist, dans lequel le module de nettoyage par produit chimique liquide a un premier module de nettoyage humide pour nettoyer le substrat avec du SC1 ; et un deuxième module de nettoyage humide pour nettoyer avec une solution aqueuse de fluorure d'hydrogène le substrat qui a été nettoyé dans le premier module de nettoyage humide, dans lequel le programme comprend en outre un module de séchage pour sécher le substrat qui a été nettoyé dans le deuxième module de nettoyage humide, et dans lequel le module d'exposition de dépôt expose le substrat qui a été séché dans le module de séchage à l'atmosphère du gaz mélangé contenant de l'ammoniac et du fluorure d'hydrogène sous la pression prédéterminée.

**23.** Programme selon la revendication 18, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le programme comprend en outre un module d'enlèvement de photorésist pour enlever la couche de photorésist, dans lequel le module de nettoyage par produit chimique liquide a un premier module de nettoyage humide pour nettoyer le substrat avec du SC 1 ; et un deuxième module de nettoyage humide pour nettoyer avec du SC2 le substrat qui a été nettoyé dans le premier module de nettoyage humide, dans lequel le programme comprend en outre un module de séchage pour sécher le substrat qui a été nettoyé dans le deuxième module de nettoyage humide, et dans lequel le module d'exposition de dépôt expose le substrat qui a été séché dans le module de séchage à l'atmosphère du gaz mélangé contenant de l'ammoniac et du fluorure d'hydrogène sous la pression prédéterminée.

**24.** Programme selon la revendication 18, dans lequel le substrat a une première couche formée sur le substrat, une couche de photorésist ayant un motif prédéterminé formé sur la première couche, et au moins un trou de connexion fabriqué dans la première couche par gravure en utilisant la couche de photorésist, dans lequel le programme comprend en outre un module d'enlèvement de photorésist pour enlever la couche de photorésist, dans lequel le module de nettoyage par produit chimique liquide a un premier module de nettoyage humide pour nettoyer le substrat avec du SC1 ; un deuxième module de nettoyage humide pour nettoyer avec une solution aqueuse de fluorure d'hydrogène le substrat qui a été nettoyé dans le premier module de nettoyage humide ; et un troisième module de nettoyage humide pour nettoyer avec du SC2 le substrat qui a été nettoyé dans le deuxième module de nettoyage humide, dans lequel le programme comprend en outre un module de séchage pour sécher le substrat qui a été nettoyé dans le troisième module de nettoyage humide, et dans lequel le module d'exposition de dépôt expose le substrat qui a été séché dans le module de séchage à l'atmosphère du gaz mélangé contenant de l'ammoniac et du fluorure d'hydrogène sous la pression prédéterminée.

EP 1 696 476 B1

FIG. 1

29

## FIG. 2A

## FIG. 2B

## FIG. 3

EP 1 696 476 B1

## FIG. 4

EP 1 696 476 B1

# FIG. 5

EP 1 696 476 B1

## FIG. 6A

301 302 303    301    302

W

## FIG. 6B

301    303 305 304    301

W

## FIG. 6C

301    303 305 306    301

W

## FIG. 6D

301    303 306 306    301

W

## FIG. 6E

301    303    301

W

## FIG. 6F

301    303    307    301

W

## FIG. 6G

301    303  NH₃   HF  307    301

W

## FIG. 6H

301    303  NH₃   HF  308    301

W

## FIG. 6I

NH₃    NH₃
SiF₄    SiF₄
301  303    301

W

## FIG. 7

## FIG. 8

400

410

10

420

## FIG. 9

## FIG. 10

160

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002166237 A

- US 5282925 A

**Non-patent literature cited in the description**

- **KUMI MOTAI ; TOSHIHIKO ITOGA ; TAKASHI IRIE.** The Effect of Isopropyl Alcohol Adsorption on the Electrical Characteristics of Thin Oxide. *Jpn. J. Appl. Phys.,* 30 March 1998, vol. 37 (3B), 1137-1139

- **JUNGYUP KIM et al.** Megasonic free single wafer ozone jet cleans- concept and feasibility. *IEEE INTERNATIONAL SYMPOSIUM ON SEMICONDUCTOR MANUFACTURING,* 2003